(19) Europäisches Patentamt
European Patent Office
Office européen des brevets

(11) **EP 0 706 054 B1**

(12) **EUROPÄISCHE PATENTSCHRIFT**

(45) Veröffentlichungstag und Bekanntmachung des Hinweises auf die Patenterteilung:
**30.12.1998 Patentblatt 1998/53**

(51) Int Cl.⁶: **G01R 25/08**, G01R 29/16

(21) Anmeldenummer: **95115746.0**

(22) Anmeldetag: **06.10.1995**

(54) **Phasenvergleicher**

Phase comparator

Comparateur de phase

(84) Benannte Vertragsstaaten:
**AT BE CH DE DK FR GB IT LI NL SE**

(30) Priorität: **07.10.1994 DE 4435905**

(43) Veröffentlichungstag der Anmeldung:
**10.04.1996 Patentblatt 1996/15**

(73) Patentinhaber:
- **Hachmann, Werner**
  **42555 Velbert-Langenberg (DE)**
- **Hachmann, Stefan**
  **42555 Velbert-Langenberg (DE)**

(72) Erfinder:
- **Hachmann, Werner**
  **42555 Velbert-Langenberg (DE)**
- **Hachmann, Stefan**
  **42555 Velbert-Langenberg (DE)**

(74) Vertreter: **Wolgast, Rudolf, Dipl.-Chem. Dr. et al**
**Dipl.-Phys. Jürgen Weisse,**
**Dipl.-Chem. Dr. Rudolf Wolgast,**
**Postfach 11 03 86**
**42531 Velbert (DE)**

(56) Entgegenhaltungen:
**EP-A- 0 190 455          EP-A- 0 599 648**

- **ELEKTROTECHNISCHE ZEITSCHRIFT, AUSGABE B, Bd. 25, Nr. 11, Juni 1973, BERLIN DE, Seiten 267-270, XP002020133 HAUG: "DIGITALE METHODEN DER PHASENMESSUNG"**
- **DATABASE WPI Section EI, Week 8136 Derwent Publications Ltd., London, GB; Class S01, AN 81-J3397D XP002020134 & SU-A-779 903 (OMSK RAIL TRANSPORT) , 19.November 1980**

## Beschreibung

Die Erfindung betrifft Phasenvergleicher zum Messen von Phasenwinkeln zwischen zwei Wechselspannungen mit Mitteln zum Erzeugen eines Zeittaktes.

Solche Phasenvergleicher dienen vornehmlich zur Prüfung von Mittelspannungsanlagen. Mittelspannungsanlagen sind Anlagen, die mit Wechselspannungen zwischen 1 und 52 Kilovolt (kV) arbeiten. Es gilt den Betriebszustand solcher Mittelspannungsanlagen festzustellen. Dazu ist festzustellen, ob eine bestimmte Phase der Wechselspannung überhaupt vorhanden ist. Ferner soll die Phasendifferenz zwischen zwei an verschiedenen Punkten abgegriffenen Wechselspannungen festgestellt werden. Dabei gelten Wechselspannungen mit einer Phasendifferenz bis zu 15° noch als phasengleich. Bei Wechselspannungen mit Phasendifferenzen von mehr als 60° liegt eindeutig Phasenungleichheit vor. Dazwischen liegt ein Übergangsbereich.

Um bei den Messungen mit handhabbaren Spannungen arbeiten zu können, werden von den Spannungen mittels eines kapazitiven Spannungsteilers Teilspannungen in der Größenordnung von wenigen Volt abgegriffen. Diese werden dann weiterverarbeitet (DIN VDE 0681 Teil 7). Der Phasenvergleicher liefert dann "binäre" Anzeigen in der Form "Spannung vorhanden", "Phasen gleich" oder "Phasen ungleich". Die Anzeigen können z.B. durch Leuchtdioden erfolgen.

Es ist wesentlich, daß der Phasenvergleicher mit Sicherheit selbst funktionsfähig ist. Eine Fehlanzeige durch Fehlfunktion des Phasenvergleichers kann schwerwiegende Konsequenzen haben.

In der "Elektrotechnischen Zeitschrift" (Ausgabe B, Bd.25, Nr.11) wird ein Verfahren zum Phasenvergleichen gezeigt. Bei diesem Verfahren wird mit einem Nulldurchgang einer ersten Wechselspannung ein Zähler gestartet. Mit dem Nulldurchgang einer zweiten Wechselspannung wird der Zähler angehalten. Der Zähler zählt die Takte eines Taktgebers. Die Anzahl der Takte ist ein Maß für die Phasenverschiebung. Ein gravierender Nachteil bei diesem Verfahren ist, daß wenn die Phasen sich in ihrer Frequenz unterscheiden oder ein "Offset" beider oder einer Phase vorliegt, dies nicht durch das Meßverfahren erfaßt wird. Außerdem können bei diesem Verfahren Netzstörungen wie Oberwellen, Spikes und "Brownouts" zu Fehlanzeigen führen.

Aus der EP-A-0 190 455 ist bereits bekannt die Gleichspannungsanteile einer Wechselspannung bei kapazitiven Wechselspannungsteilern zu beseitigen.

Der Erfindung liegt die Aufgabe zugrunde, einen verbesserten Phasenvergleicher für die vorliegenden oder ähnliche Zwecke zu schaffen.

Insbesondere liegt der Erfindung die Aufgabe zugrunde, einen Phasenvergleicher zu schaffen, der einfach aufgebaut ist und zuverlässig arbeitet.

Der erfindungsgemäße Phasenvergleicher zum Messen von Phasenwinkeln zwischen zwei Wechselspannungen mit Mitteln zum Erzeugen eines Zeittaktes ist gekennzeichnet durch Nullpunktschalter zum Bestimmen der Zeitpunkte von wenigstens jeweils drei Nulldurchgängen jeder Wechselspannung in Bezug auf diesen Zeittakt, und Mittel zum Bestimmen der Phasenlagen jeder Wechselspannung bezogen auf die Zeittakte und Mittel zum Bestimmen der Differenz der so ermittelten Phasenlagen.

Das Grundprinzip des Phasenvergleichs nach der Erfindung ist somit folgendes: Von jeder der beiden Wechselspannungen werden die Zeitpunkte von wenigstens drei Nulldurchgängen bezogen auf einen festen Zeittakt bestimmt. Aus der Lage dieser Nulldurchgänge bezogen auf den Zeittakt kann die Phase jeder der Wechselspannungen in bezug auf den Zeittakt bestimmt werden. Dann wird die Differenz der so bestimmten Phasen in Form einer entsprechenden Anzahl von Zeittakten bestimmt.

Jede der Wechselspannungen kann u.U. gegen die Nullinie etwas versetzt sein. Die Nulldurchgänge folgen dann nicht in genau gleichen Abständen aufeinander. Es ist etwa das Zeitintervall zwischen dem ersten (ansteigenden) und dem zweiten (abfallenden) Nulldurchgang kleiner als das Zeitintervall zwischen dem zweiten (abfallenden) und dem dritten (ansteigenden) Nulldurchgang. Das zeigt an, daß die Nullinie der Messung relativ zu der Wechselspannung nach oben versetzt ist. Ist es größer, zeigt es an, daß die Nullinie der Messung relativ zu der Wechselspannung nach unten versetzt ist. Der Versatz ist umso größer, je größer der Unterschied der Zeitintervalle ist.

Die "Mittel zum Bestimmen der Phasenlagen" enthalten daher in weiterer Ausbildung der Erfindung Mittel zur Bestimmung und rechnerischen Berücksichtigung eines Nullinien-Versatzes der Wechselspannungen aus ungleichen Zeitabständen der Nulldurchgänge.

Auf diese Weise wird die Messung und Korrektur eines Nullinien-Versatzes zurückgeführt auf eine Zählung von Zeittakten.

Vor dem Phasenvergleich wird vorzugsweise festgestellt, ob überhaupt Wechselspannungen ausreichender Amplitude in den Meßpunkten vorhanden sind. Das kann geschehen durch je einen Schwellwertschalter für jede der beiden Wechselspannungen, auf den die Wechselspannung aufgeschaltet ist, Mittel zur Bestimmung des Zeitintervalls, während welcher der Schwellwert durch die jeweilige Wechselspannung überschritten ist, und Mittel zur Anzeige, ob das Zeitintervall einen vorgegebenen Grenzwert unterschreitet als Anzeichen für das Vorhandensein oder Nichtvorhandensein der Wechselspannung.

Ist die Amplitude der Wechselspannung zwar größer als der Schwellwert des Schwellwertschalters, übersteigt diesen Schwellwert aber nur geringfügig, dann ist die Wechselspannung nur während eines kurzen Zeitintervalls größer als der Schwellwert. Dieses Zeitintervall wird, z.B. als Anzahl von Zeittakten, bestimmt. Ist dagegen die Amplitude der Wechselspannung groß gegen den Schwellwert des Schwellwertschalters, dann liegt die Wechselspannung während praktisch der vollen Halbperiode oberhalb des Schwellwertes. Es kann nun ein Grenzwert-Zeitintervall festgelegt werden: Ist das Zeitintervall, während dessen die Wechselspannung den Schwellwert des Schwellwertschalters überschreitet, kürzer als dieses Grenzwert-Zeitintervall, dann bedeutet dies: "Keine Spannung". Ist das Zeitintervall während dessen die Wechselspannung den Schwellwert des Schwellwertschalters überschreitet, länger als dieses Grenzwert-Zeitintervall, dann bedeutet dies: "Spannung vorhanden". Auch hier wird die Spannungsmessung auf eine Zählung von Zeittakten zurückgeführt.

Vorzugsweise sind weiterhin Mittel zur Prüfung der Frequenzgleichheit der beiden Wechselspannungen vor der Bestimmung der Differenz der Phasen vorgesehen. Damit wird sichergestellt, daß die Frequenzen der beiden Wechselspannungen hinreichend genau übereinstimmen, um eine sinnvolle Phasenmessung zu ermöglichen. Die Frequenzen können aus den Anzahlen der Zeittakte im Intervall zwischen dem einen Nulldurchgang und dem übernächsten bestimmt werden. Die Frequenzmessung ist daher ebenfalls auf eine Zählung von Zeittakten zurückgeführt. Der Frequenzvergleich besteht in einem Vergleich von Zeittakt-Zahlen.

Die Mittel zum Prüfen der Frequenzgleichheit, die Mittel zum Bestimmen der Phasenlagen und der Differenz der Phasenlagen, die Mittel zur Bestimmung des Nullinien-Versatzes und die zeitintervallbestimmenden und -auswertenden Mittel können von einem hierfür programmierten Mikroprozessor gebildet sein. Stattdessen kan aber auch z.B. ein anwenderspezifischer integrierter Schaltkreis (ASIC) für diese Funktionen vorgesehen werden.

Der Phasenvergleicher kann weiterhin Selbstprüfungsmittel zur Prüfung der Funktionsfähigkeit des Phasenvergleichers enthalten. Diese Selbstprüfungsmittel können Mittel zur Kontrolle der Batteriespannung einer den Phasenvergleicher speisenden Batterie, Mittel zum Prüfen von Anzeige-Bauteilen, durch welche Ergebnisse des Phasenvergleichers anzeigbar sind, z.B. von Leuchtdioden, und Mittel zur Selbstprüfung der Phasenmessung enthalten.

Ein Ausführungsbeispiel der Erfindung ist nachstehend unter Bezugnahme auf die zugehörigen Zeichnungen näher erläutert:

Fig.1 ist eine schematische Darstellung eines Spannungs-Anzeigesystems, bei welchem der Phasenvergleicher angewandt wird.

Fig.2 ist ein Blockschaltbild eines Phasenvergleichers.

Fig.3 zeigt eine Ausführung der Eingangsimpedanz bei der Schaltung von Fig.2.

Fig.4 zeigt den Aufbau des Nullspannungs-Schalters bei der Schaltung von Fig.2.

Fig.5 zeigt den Aufbau des Schwellwert-Schalters bei der Schaltung von Fig.2.

Fig.6 zeigt den Signalverlauf der Wechselspannung, die einen Nullinien-Versatz zeigt, und das zugehörige Ausgangssignal des Nullpunkt-Schalters mit drei Nulldurchgängen, das dem Mikroprozessor zugeführt wird.

Fig.7 veranschaulicht die Wirkungsweise des Schwellwert-Schalters von Fig.2 und zeigt zwei Wechselspannung unterschiedlicher Amplitude und ihr Verhältnis zu dem Schwellwert des Schwellwert-Schalters.

Fig.8 zeigt eine Abwandlung der Schaltung zur Erueugung eines "Spannung vorhanden"-Signals mittels eines Schwellwert-Schalters.

Fig.9 zeigt die Stromversorgung des Mikroprozessors mittels eines Tasters.

Fig.10 zeigt die Schaltung von Leuchtdioden zur Anzeige des Betriebszustandes der überprüften Mittelspannungs-Anlage.

Fig.11 zeigt eine Schaltung zur Überprüfung der Funktion der Leuchtdioden.

Fig.12 zeigt eine Schaltung zur internen Erzeugung von Wechchelspannungen für Selbstprüfungszwecke.

Fig. 13 zeigt eine Schaltung zur Durchführung einer Batterie-Prüfung.

Fig. 14 ist ein Ablaufdiagramm für das Einschalten des Mikroprozessors.

Fig.15 zeigt einen ersten Abschnitt eines Ablaufdiagramms für die Selbstprüfung des Phasenvergleichers.

Fig.16 zeigt einen zweiten Abschnitt des Ablaufdiagramms für die Selbstprüfung des Phasenvergleichers.

Fig.17 zeigt einen dritten Abschnitt des Ablaufdiagramms für die Selbstprüfung des Phasenvergleichers.

Fig.18 zeigt ein Ablaufdiagramm für die interne Signalerzeugung nach Maßgabe der in der Wertetabelle gespeicherten Werte.

Fig.19 zeigt ein Ablaufdiagramm für eine Programm-Unterbrechung (Interrupt-Routine) zur Auslesung von gespeicherten Werten einer Wertetabelle.

Fig.20 zeigt eine Tabelle mit den Fallunterscheidungen der Meßroutine.

Fig.21 zeigt ein Ablaufdiagramm des Phasenvergleichs bei der Meßroutine.

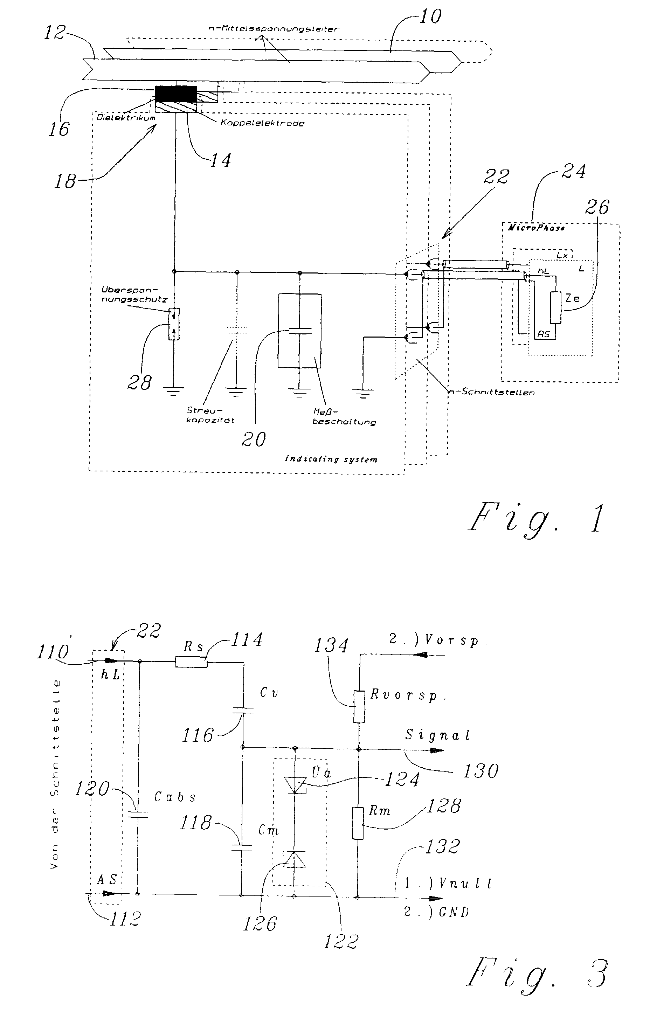

Fig.1 veranschaulicht die Anwendung des Phasenvergleichers zur Bestimmung des Betriebszustandes einer Mittelspannungs-Anlage, d.h. einer Anlage mit Spannungen zwischen 1 kV und 52 kV. Die Mittelspannungs-Anlage enthält ein n-phasiges System, von diesem sind zwei Leitungen 10 und 12, an denen die zu prüfenden hohen Spannungen liegen. Von jeder der Leitungen wird eine verarbeitbare Teilspannung kapazitiv abgegriffen. Hierzu dient eine Koppelelektrode 14 mit einem Dielektrikum 16. Diese Koppelelektrode 14 bildet mit der Leitung, z.B. 12, und dem dazwischenliegenden Dielektrikum einen ersten Kondensator 18. Der erste Kondensator 18 bildet mit einem zweiten Kondensator 20 einen kapazitiven Spannungsteiler zwischen Leitung 12 und Erde. An dem Kondensator 20 wird eine der Spannung auf der Leitung 12 (oder 10) proportionale und mit dieser im wesentlichen phasengleiche Teilspannung abgegriffen. Diese Teilspannung liegt über eine Schnittstelle 22 an einem noch zu beschreibenden Phasenvergleicher 24 an. Der Phasenvergleicher 24 hat Eingangsimpedanzen, die hier durch einen Widerstand 26 repräsentiert sind. Parallel zu dem Kondensator 20 liegt ein Überspannungsschutz 28. Das ist an sich bekannt und dient nur der Erläuterung des Einsatzes des Phasenvergleichers.

Fig.2 ist ein Blockschaltbild des Phasenvergleichers 24. An den Phasenvergleicher 24 sind über zwei Eingänge 30 und 32 zwei Wechselspannungen anlegbar, die mit L und $L_x$ bezeichnet sind. Die Wechselspannung L liegt über eine Eingangsimpedanz 34 parallel einmal an einem Nullpunkt-Schalter 36 und zum anderen an einem Schwellwert-Schalter 38. Der Ausgang des Nullpunkt-Schalters 36 liegt an einem Eingang 40 eines Rechners 42. Der Rechner 42 ist hier von einem Microcontroller gebildet, der unter der Bezeichnung PIC 16C84 handelsüblich erhältlich ist. Die am Ausgang des Schwellwert-Schalters 38 erhaltenen Signale werden in noch zu beschreibender Weise von einer Signalaufbereitungs-Schaltung 44 verarbeitet und liefern ein Signal an einem Eingang 46 des Rechners 42. Die Signale von dem Nullpunkt-Schalter 36 sind Rechteck-Spannungen und liefern wenigstens drei aufeinanderfolgende Nulldurchgänge der Wechselspannung L. Das Signal von der Signalaufbereitungs-Schaltung 44 ist ein binäres Signal und signallisiert, ob überhaupt eine Wechselspannung L anliegt oder nicht. In entsprechender Weise liegt die Wechselspannung $L_x$ über eine Eingangsimpedanz 48 parallel einmal an einem Nullpunkt-Schalter 50 und zum anderen an einem Schwellwert-Schalter 52. Der Ausgang des Nullpunkt-Schalters 50 liegt an einem Eingang 54 des Rechners 42. Die am Ausgang des Schwellwert-Schalters 52 erhaltenen Signale werden ebenfalls von einer Signalaufbereitungs-Schaltung 56 ähnlich der Signalaufbereitungs-Schaltung 44 verarbeitet und liefern ein Signal an einem Eingang 58 des Rechners 42. Die Signale von dem Nullpunkt-Schalter 50 sind wieder Rechteck-Spannungen und liefern wenigstens drei aufeinanderfolgende Nulldurchgänge der Wechselspannung $L_x$. Das Signal von der Signalaufbereitungs-Schaltung 56 ist ein binäres Signal und signallisiert, ob eine Wechselspannung $L_x$ anliegt.

Der Rechner 42 erhält einen Zeittakt von einem Taktgenerator 60.

Der Rechner 42 steuert seine Betriebsspannung, und die Betriebsspannung des Phasenvergleichers 24 von einer Stromversorgung 62 über eine EIN/AUS-Schaltung 64 und einen Steuereingang 66. Die Spannung der Betriebsspannung ist durch eine Stabilisierungs-Schaltung 68 stabilisiert.

An einem Port 70 liegen Schaltungen 72 und 74 zur Porterweiterung. Dadurch werden zusätzliche Ports für die Anzeigevorrichtung 76 und für einen durch Block 78 dargestellten Schalter zur Steuerung der Selbstprüfung geschaffen. Die Selbstprüfung umfaßt eine durch einen Block dargestellte Schaltung 80 zur Batterieprüfung sowie die Prüfung der Abschirmungen der Leitungen für die Wechselspannungen L und $L_x$, was durch Blöcke 82 bzw. 84 dargestellt ist. Für die Selbstprüfung ist weiterhin ein "Fensterkomparator" 86 zur Prüfung der Brennspannungen der für die Anzeige verwendeten Leuchtdioden vorgesehen.

An einem Port 88 des Rechners 42 liegt eine externe Überwachungs-Schaltung ("Watchdog"). Der Port 88 ist außerdem mit einer Schaltung 92 verbunden. Die Schaltung 92 erzeugt und speist zwei Verstärker 94 und 96 mit der für die Sinuserzeugung benötigten höheren Spannung. Ports 98 und 100 liefern, wie noch beschrieben wird, Pulsbreiten-Signale. Aus diesen Pulsbreiten-Signalen werden durch Schaltungen 102 bzw. 104 Sinussignale für die Selbstprüfung des Phasenvergleichs erzeugt. Diese Sinussignale werden durch die Verstärker 94 bzw. 96 verstärkt und liegen an Klemmen 106 bzw. 108.

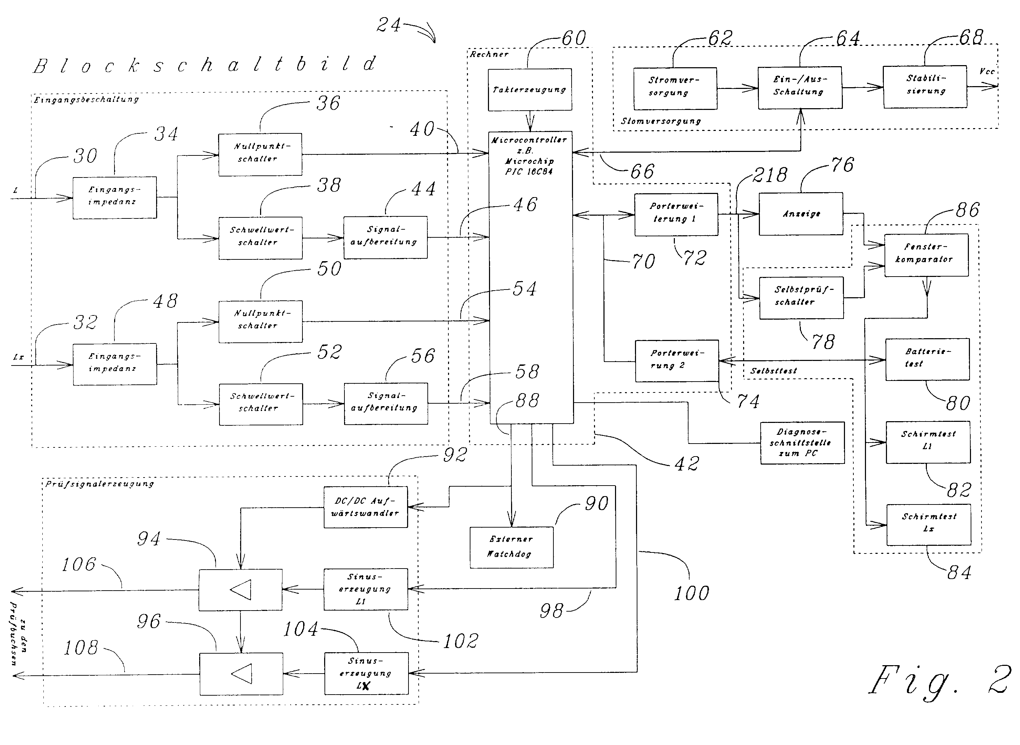

Die Schaltung der Eingangsimpedanzen 34 und 48 ist in Fig.3 dargestellt.

An den Klemmen 110 und 112 der Schnittstelle 22 liegt über einen Widerstand 114 nochmals ein kapazitiver Spannungsteiler bestehend aus Kondensatoren 116 und 118. Der Widerstand 114 schützt die Kondensatoren 116 und 118 vor kritischen Spannungsanstiegsgeschwindigkeiten $D_u/D_t$ und kompensiert die phasenverschiebende Komponente des Realteils der Parallelschaltung aus Kondensator 118, der gegeneinander geschalteten Z-Dioden 124 und 126 und des Meßwiderstands 128. Zwischen den Klemmen 110 und 112 liegt die durch die Anschlußletung verursachte Kabel-Kapazität 120 des Anschlußkabels. Parallel zu dem Kondensator 118 liegt eine Überspannungsicherung 122 bestehend aus zwei gegeneinandergeschalteten Zenerdioden 124 und 126. Eine an einem Widerstand 128 abfallende Wechselspannung liegt zwischen zwei Klemmen 130 und 132. Wird die Klemme 132 nicht als virtueller Nullpunkt geschaltet, sondern auf GND (Gerätemasse) gelegt, so ist die Klemme 130 über einen Widerstand 134 mit einer Vorspannung zu belegen.

Die Spannung an der Klemme 130 liegt über einen Widerstand 134 (Fig.4) an einem Eingang eines Operationsverstärkers 136. Die an dem Eingang des Operationsverstärkers anliegende Spannung ist begrenzt durch Dioden 138 und 140. Der Widerstand 134 und die Dioden 138 und 140 schützen den Eingang des Operationsverstärkers 136 gegen Überspannungen, welche größer sind, als seine Versorgungsspannung. An dem zweiten Eingang des Operationsverstärkers 136 liegt eine Referenzspannung von einem Referenzspannungs-Erzeuger 142.

Die Spannung an der Klemme 130 liegt weiterhin über einen Widerstand 144 (Fig.5) an einem Eingang eines Operationsverstärkers 146. Die an dem Eingang des Operationsverstärkers 146 anliegende Spannung ist ebenfalls begrenzt durch Dioden 148 und 150. Der Widerstand 144 und die Dioden 148 und 150 schützen wieder den Eingang des Operationsverstärkers 146 gegen Spannungen, welche größer als die Versorgungsspannung sind. An dem zweiten Eingang des Operationsverstärkers 146 liegt eine Referenzspannung von einem Referenzspannungs-Erzeuger 152.

Die Schaltung von Fig.4 stellt den Nullspannungs-Schalter 36 oder den Nullspannungs-Schalter 50 von Fig.2 dar. Die Schaltung von Fig.5 stellt den Schwellwert-Schalter 38 oder den Schwellwert-Schalter 52 von Fig.2 dar.

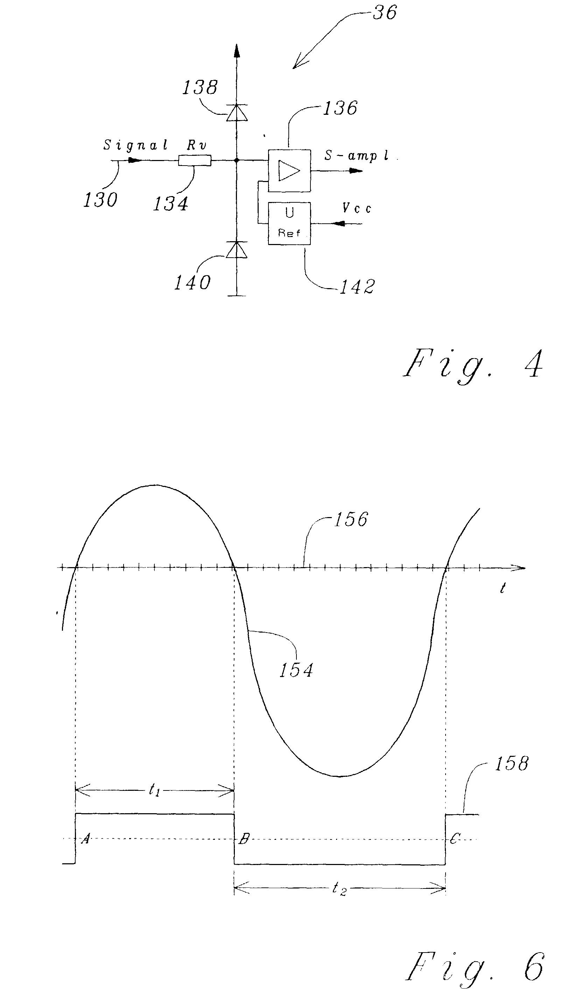

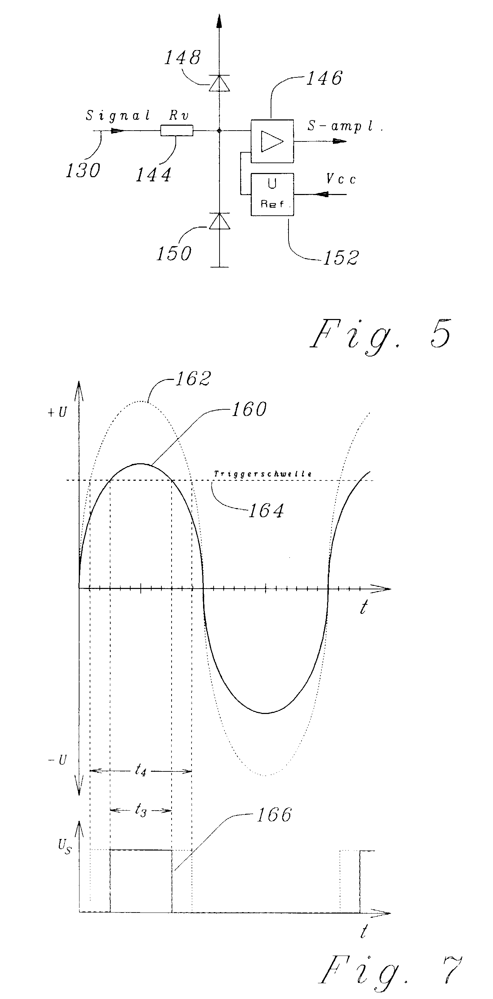

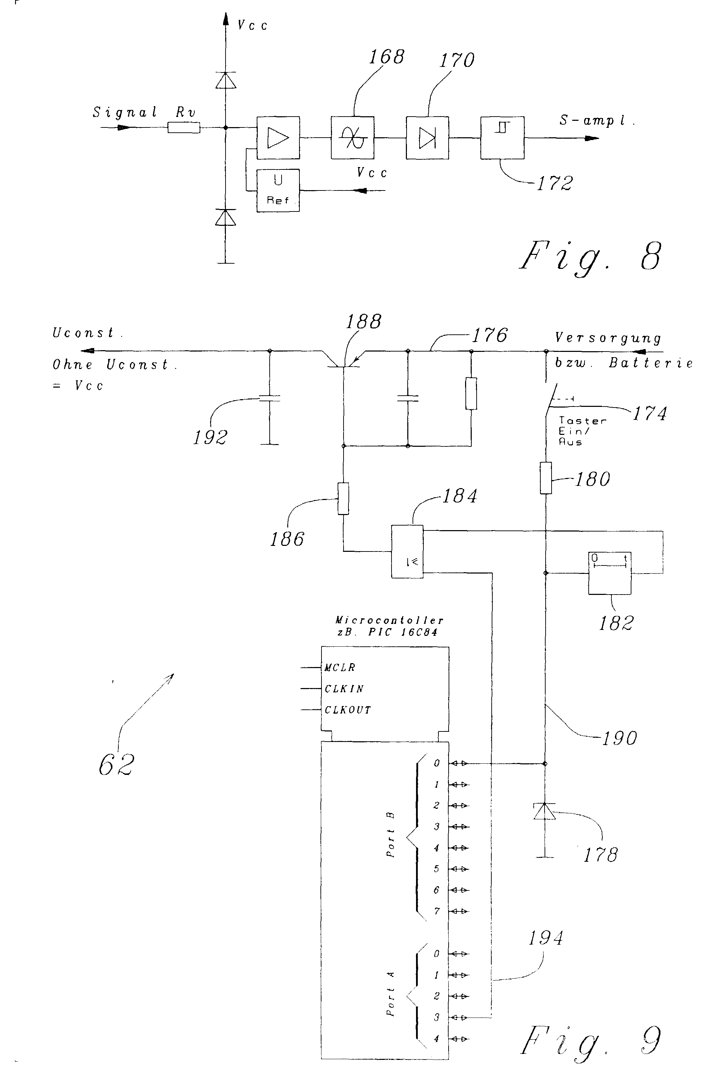

Die Wirkungsweise der Nullspannungs-Schalter 36 oder 50 ist anhand von Fig.6 näher erläutert.

In Fig.6 ist eine zu prüfende Wechselspannung als sinusförmiger Signalverlauf 154 dargestellt. Auf der Zeitachse t sind schematisch die von dem Takterzeuger 60 vorgegebenen Zeittakte 156 markiert. Wie man sieht, ist die Wechselspannung etwas gegenüber der durch die Zeitachse symbolisierten Nullinie versetzt (dieser Versatz kann ein positives bzw. ein negatives Vorzeichen haben und ist durch die Bauteiletoleranzen bedingt). Der Operationsverstärker 136 macht daraus eine Rechteckspannung 158, wie sie im unteren Teil von Fig. 6 dargestellt ist. Die Flanken der Rechteckspannung 158 definieren drei Nulldurchgänge A, B und C der Wechselspannung 154. Infolge des Nullinien-Versatzes sind die Zeitabstände $t_1$, $t_2$ zwischen den Nulldurchgängen A und B und zwischen den Nulldurchgängen B und C ungleich. Die Nulldurchgänge werden dem Rechner zugeführt. Die Anzahl der Zeittakte 156 in den Zeitabständen $t_1$ und $t_2$ werden gezählt. Aus den Unterschieden der Anzahlen der Zeittakte 156 bestimmt der Rechner 42 den Nullinien-Versatz und die korrekte Phase der Wechselspannung in bezug auf den Zeittakt.

Die Referenzspannung von dem Referenzspannungs-Erzeuger 142 dient hier dazu, einen wenigstens annähernden Nullinien-Abgleich vorzunehmen.

Fig.7 veranschaulicht, wie unter Verwendung des Schwellwertschalters von Fig.5 ein Signal dafür gewonnen wird, ob eine Wechselspannung überhaupt vorhanden ist oder nicht. Mit 160 ist der Signalverlauf einer an dem Operationsverstärker 146 anliegenden Wechselspannung relativ geringer Amplitude bezeichnet. Mit 162 ist der Signalverlauf einer an dem Operationsverstärker 146 anliegenden Wechselspannung relativ großer Amplitude bezeichnet. Der Schwellwert-Schalter 38 mit dem Operationsverstärker 146 und dem Referenzspannungs-Erzeuger 152 legt einen Schwellwert 164 fest. Die beiden Wechselspannungen überschreiten den Schwellwert in einem mittleren Bereich um das Maximum herum. Im Falle der Wechselspannung 160 wird der Schwellwert 164 von dem Signalverlauf in einem Zeitintervall $t_3$ überschritten. Im Falle der Wechselspannung 162 wird der Schwellwert 164 durch den Signalverlauf in einem Zeitintervall $t_4$ überschritten, das größer ist als das Zeitintervall $t_3$. Der Operationsverstärker 146 liefert Rechtecksignale wie das Rechtecksignal 166. Diese Rechtecksignale 166 sind auf den Rechner 42 aufgeschaltet. Der Rechner 42 bestimmt die Länge der Rechtecksignale 166 durch Zählung der während des Anstehens der Rechtecksignale 166 erscheinenden Zeittakte des Taktgenerators 60. Wenn die Anzahl der so gezählten Zeittakte kleiner als ein bestimmter Grenzwert ist, dann signalisiert der Rechner: "Keine Spannung". Ist dagegen die Anzahl der gezählten Zeittakte größer als der Grenzwert, wird "Spannung vorhanden" signalisiert.

Um den Rechner 42 von der Aufgabe der Zählung der Zeittakte zu entlasten, kann auch die Anordnung von Fig.8 verwendet werden. Dabei wird das Überschreiten oder Unterschreiten des Grenzwertes analog festgestellt und dementsprechend ein einziges binäres Signal erzeugt, das auf den Rechner 42 aufgeschaltet ist.

Bei der Anordnung nach Fig.8 ist ebenfalls ein Schwellwert-Schalter nach Art von Fig.5 vorgesehen. Entsprechende Teile sind in Fig.8 mit den gleichen Bezugszeichen versehen wie in Fig.5. Das Ausgangssignal des Schwellwert-Schalters ist, wie unter Bezugnahme auf Fig.7 erläutert wurde, eine Folge von impulsen, deren Impulsbreite von der Amplitude der Wechselspannung abhängt. Diese Impulse werden nun durch ein Filter 168 gefiltert und durch einen Gleichrichter 170 gleichgerichtet. Dadurch wird eine Gleichspannung erhalten, deren Höhe von der Impulsbreite der Impulse abhängig ist. Die Gleichspannung ist auf einen Schmitt-Trigger 172 geschaltet. Der Schmitt-Trigger 172 geht in einen ersten, das Vorhandensein einer Wechselspannung signalisierenden Schaltzustand, wenn die Gleichspannung einen bestimmten Grenzwert überschreitet. Der Schmitt-Trigger 172 geht in einen zweiten, das Nichtvorhandensein einer Wechselspannung signalisierenden Schaltzustand, wenn die Gleichspannung den Grenzwert unterschreitet. Das so von dem Schmitt-Trigger erhaltene binäre Signal (1 oder 0) ist ebenfalls auf den Rechner 42 geschaltet.

Fig.9 zeigt im einzelnen die EIN/AUS-Schaltung 64 von Fig.2.

Der Phasenvergleicher 24 wird durch einen Taster 174 ein- und ausgeschaltet. Wenn der Phasenvergleicher 24 eingeschaltet ist, dann muß er durch einen Tastendruck ausgeschaltet werden. Wenn der Phasenvergleicher 24 ausgeschaltet ist, muß der Tastendruck eine Einschaltung bewirken.

Bei vorübergehendem Betätigen des Tasters 174 wird von der Versorgungsspannung von der Stromversorgung (Batterie) 62 auf der Leitung 176 eine durch eine Zenerdiode 178 bestimmte Teilspannung über einen Widerstand 180 auf eine monostabile Kippstufe 182 gegeben. Die monostabile Kippstufe 182 steuert über ein ODER-Glied 184 und einen Widerstand 186 einen Längstransistor 188 an, der mit seiner Emitter-Kollektor-Strecke in der Leitung 176 liegt und die Stromversorgung 62 (Fig.2) mit dem Port 66 des Rechners 42 verbindet. Der Impuls von der monostabilen Kippstufe 182 geht daher durch das ODER-Glied 184 hindurch. Der Rechner 42 wird an Spannung gelegt. Der Rechner 42 liefert, wenn er an Spannung liegt, ein Signal an einem Ausgang 194, der mit dem zweiten Eingang des ODER-Gliedes verbunden ist. Nach Rückstellen der monostabilen Kippstufe wird der Längstransistor über den Ausgang 194 und das ODER-Glied 184 leitend gehalten. Der Rechner 42 bleibt an die Stromversorgung 62 angeschaltet.

Wenn der Rechner 42 an die Stromversorgung 62 angeschaltet ist, dann bewirkt eine kurzfristige Betätigung des Tasters 174 über eine Eingang 190 eine Ausschaltung des Rechners 42. Eine Zener-Diode 178 begrenzt die Höhe des auf den Eingang 190 geschalteten Impulses. Wenn der Rechner 42 ausgeschaltet ist, dann entfällt die Ausgangsspannung an dem Ausgang 194 des Rechners 42. Nach Rückkippen der -wieder angestoßenen- monostabilen Kippstufe 182 wird daher der Transistor 188 gesperrt.

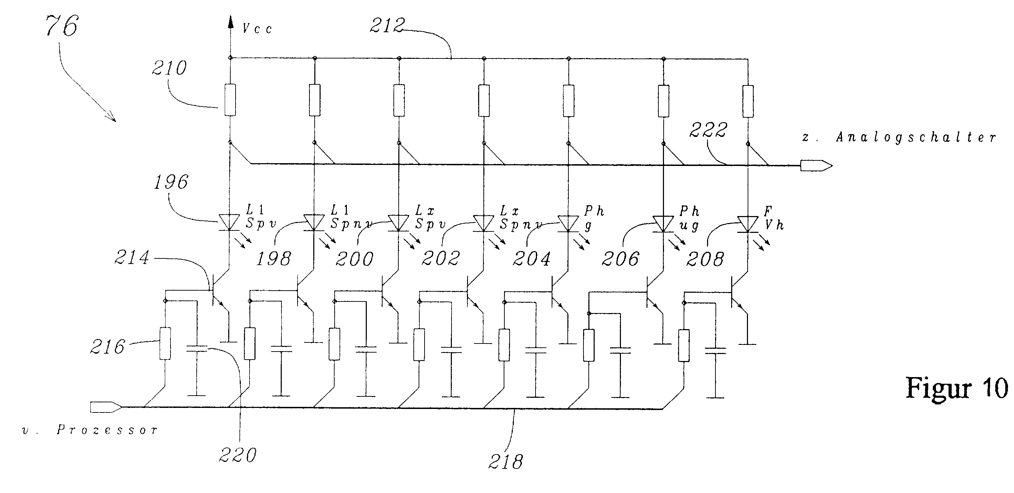

Fig.10 zeigt im einzelnen die Anzeigevorrichtung 76 von Fig.2. Die Zustände der zu prüfenden Spannungen werden "binär" als "Spannung vorhanden" oder "Spannung nicht vorhanden", "Spannungen gleichphasig" oder "Spannungen ungleichphasig" sowie "Fehlmessungen" bzw. "Störung" mittels Leuchtdioden 196, 198, 200, 202, 204, 206 und 208 angezeigt. Jede der Leuchtdioden 196 bis 208 liegt, wie anhand der Leuchtdiode 196 beschrieben wird, über einen Widerstand 210 an der Versorgungsspannung. Die Versorgungsspannung wird über eine Leitung 212 zugeführt. In Reihe mit der Leuchtdiode 196 liegt die Emitter-Kollektor-Strecke eines Transistors 214. Der Emitter des Transistors 214 liegt an GND (Gerätemasse). Die Basis des Transistors liegt über einen Widerstand 216 an einer Ader eines Bus 218, über den Steuersignale von dem Rechner 42 auf die Anzeigevorrichtung 76 aufgeschaltet werden. Außerdem liegt die Basis des Transistors 214 über einen Kondensator 220 an GND (Gerätemasse). Über die Adern eines Kabels 222 werden die an den Leuchtdioden 196 abfallenden Spannungen zu Prüfzwecken abgegriffen.

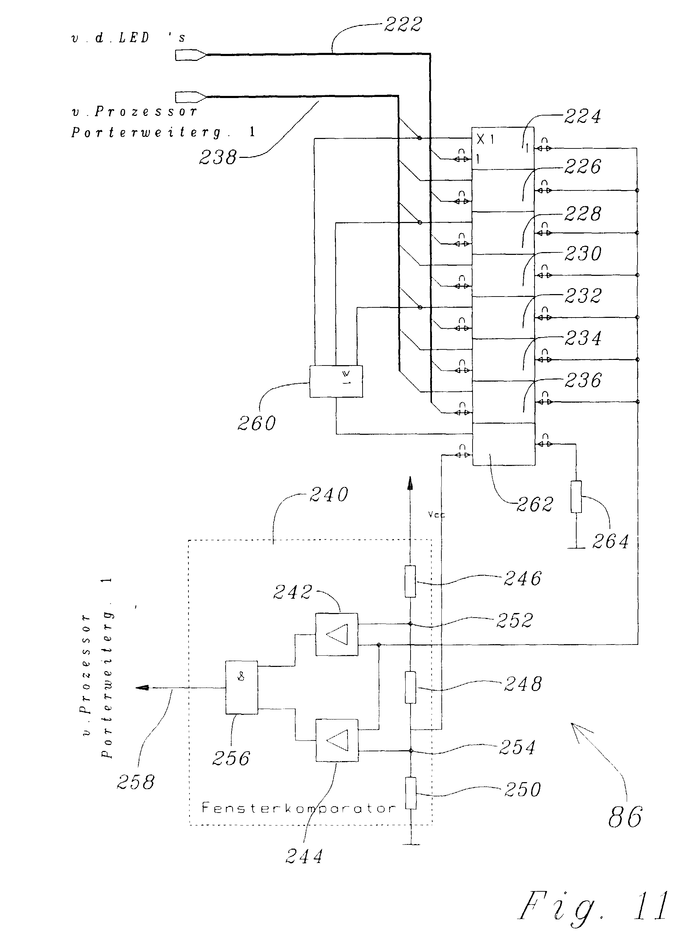

Fig.11 zeigt einen "Fensterkomparator" 86 (Fig.2) zur Prüfung der Brennspannungen der Leuchtdioden 196 bis 208 (Fig.10). Der Fensterkomparator 86 ist von dem Rechner 42 gesteuert. Er prüft, ob die Brennspannungen der Leuchtdioden innerhalb vorgegebener "Fenster" liegen. Der Fernsterkomparator 86 enthält elektronische Schalter 224, 226, 228, 230, 232, 234 und 236, die von dem Rechner über einen Bus 238 im Verlauf des Prüfprogramms nacheinander aufgesteuert werden. Jeder der elektronischen Schalter 224 bis 236 schaltet eine Ader des Kabels 222 (Fig.10) auf eine Komparator-Anordnung 240 durch. Die Komparator-Anordnung 240 enthält zwei Komparatoren 242 und 244. Die jeweils durchgeschaltete Brennspannung liegt einmal an dem "unteren" Eingang des Komparators 242 und zum anderen an dem "oberen" Eingang des Komparators 244. Ein Spannungsteiler mit drei Widerständen 246, 248 und 250, der zwischen der Versorgungsspannung und GND (Gerätemasse) liegt, liefert eine obere Referenzspannung an einem Abgriff 252 und eine untere Referenzspannung an einem Abgriff 254. Die obere Referenzspannung liegt an dem "oberen" Eingang des Komparators 242. Die untere Referenzspannung liegt an dem "unteren" Eingang des Komparators 244. Der Komparator 242 schaltet und liefert ein Ausgangssignal, wenn die an dem unteren Eingang liegende, über den jeweiligen Schalter 224 bis 236 durchgeschaltete Brennspannung kleiner als die obere Referenzspannung am Abgriff 252 ist. Der Komparator 244 schaltet und liefert ein Ausgangssignal, wenn die jeweils durchgeschaltete Brennspannung größer als die untere Referenzspannung am Abgriff 254 ist. Die Ausgänge der Komparatoren 242 und 244 sind durch ein UND-Glied 256 verknüpft. Das UND-Glied 256 liefert über seinen Ausgang 258 ein "Logisch 1" - Signal an den Rechner 42, wenn die jeweils aufgeschaltete Brennspannung in einem durch die obere und die untere Referenzspannung vorgegebenen "Fenster" liegt. Die Brennspannungen der Leuchtdioden sind unterschiedlich abhängig von der Farbe der Leuchtdiode. Im vorliegenden Fall haben die Leuchtdioden 196, 200 und 204 andere Farben als die übrigen Leuchtdioden und eine geringere Brennspannung. Um das zu berücksichtigen sind die Ansteuersignale des Rechners 42 für die zugeordneten elektronischen Schalter 224, 228 und 232 über ein ODER-Glied 260 verknüpft. Der Ausgang des ODER-Gliedes 260 steuert einen weiteren elektonischen Schalter 262 durch. Der Schalter 262 wird dann leitend und legt einen Widerstand 264 parallel zu dem Widerstand 250 des Spannungsteilers. Damit werden die obere und die untere Referenzspannung nach unten gezogen und das Fenster an die niedrigere Brennspannung der Leuchtdioden 196, 200 und 204 angepaßt.

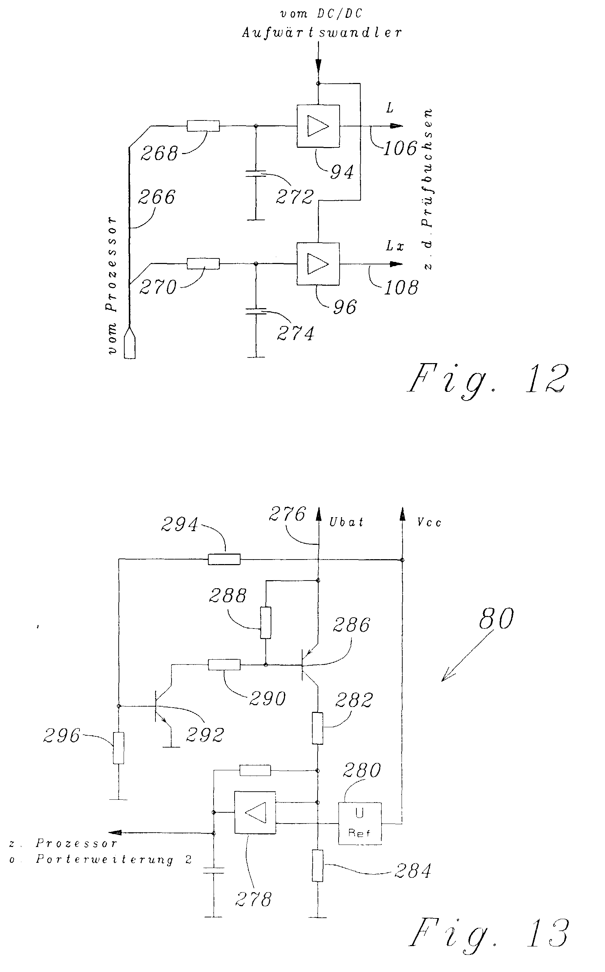

Fig. 12 zeigt im einzelnen die Bildung der sinusförmigen Prüfspannungen für die Prüfung der Phasenvergleichs-Mittel.

Von dem Rechner 42 werden zu Prüfzwecken über die Ports 98 und 100 (Fig.2) und ein Kabel 266 Impulsfolgen geliefert, bei denen sich die Pulsbreite sinusförmig ändert. Die Impulsfolgen werden durch Filter geglättet. Jedes der Filter besteht aus einem Widerstand 268 bzw. 270 und einem Kondensator 272 bzw. 274. Die geglätteten, sinusförmigen Spannungen werden durch die Verstärker 94 und 96 (siehe auch Fig.2) verstärkt. Die Verstärker 94 und 96 liefern sinusförmige Prüfspannungen mit bekannter Phasenbeziehungen an den Klemmen 106 bzw. 108.

Fig.13 zeigt die Schaltung 80 zur Batterieprüfung. Eine Teilspannung der an einer Klemme 276 anliegenden Batteriespannung wird an einem Komparator 278 mit einer Spannung eines Referenzspannungs-Erzeugers 280 verglichen. Der Referenzspannungs-Erzeuger 280 wird gespeist von der Versorgungsspannung. Die Teilspannung der Batteriespannung wird an einem Spannungsteiler mit Widerständen 282 und 284 abgegriffen. Die Versorgungsspannung wird abgeschaltet, wenn der Phasenvergleicher nicht in Betrieb ist. Über den Spannungsteiler 282, 284 würde jedoch ständig Strom fließen und die Batterie belasten. Aus diesem Grunde liegt in Reihe mit dem Spannungsteiler 282, 284 die Emitter-Kollektor-Strecke eines Transistors 286. Die Basis dieses Transistors 286 liegt an eimem zwischen der Klemme 276 und GND (Gerätemasse) liegenden Spannungsteiler mit einem Widerstand 288 und 290. In Reihe mit dem Widerstand 290 liegt noch die Emitter-Kollektor-Strecke eines Transistors 292. Die Basis des Transistors 292 liegt an einem zwischen die Versorgungsspannung und GND (Gerätemasse) geschalteten Spannungsteile mit Widerständen 294 und 296. Dadurch wird bei Abschalten der Versorgungsspannung der Transistor 292 gesperrt, und damit wird auch der Transistor 286 gesperrt.

Die Arbeitsweise des Rechners 42 und der damit zusammenwirkenden Schaltungen ist nachstehend anhand von Ablaufdiagrammen beschrieben.

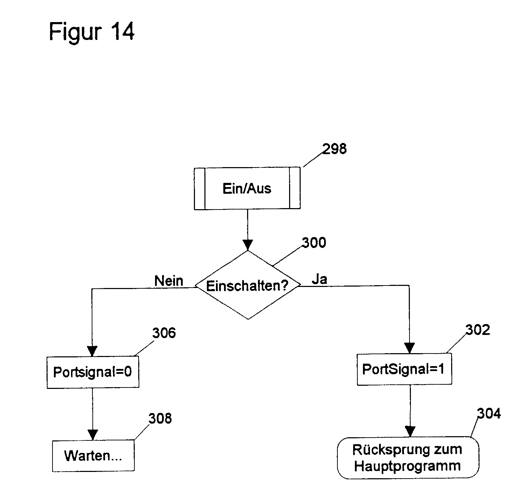

Fig. 14 illustriert den Einschaltvorgang. Ein Rechteck 298 "EIN/AUS" symbolisiert die Betätigung des Tasters 174 in Fig. 9. Ein Rhombus 300 entspricht der Prüfung, ob eine Einschaltung erfolgt oder eine Ausschaltung. Im ersteren Fall (Ja) wird das Signal am Port 194 gemäß Rechteck 302 auf "logisch 1" gesetzt. Damit wird ein Rücksprung zum Hauptprogramm eingeleitet, wie durch das Oval 304 dargestellt ist. Im zweiten Fall (Nein) erfolgt ein Rücksetzen des Signals am Port 194 auf "logisch 0". Das ist durch das Rechteck 306 dargestellt. Es erfolgt keine weitere Aktivität, wie durch das Rechteck 308 "Warten" angedeutet ist.

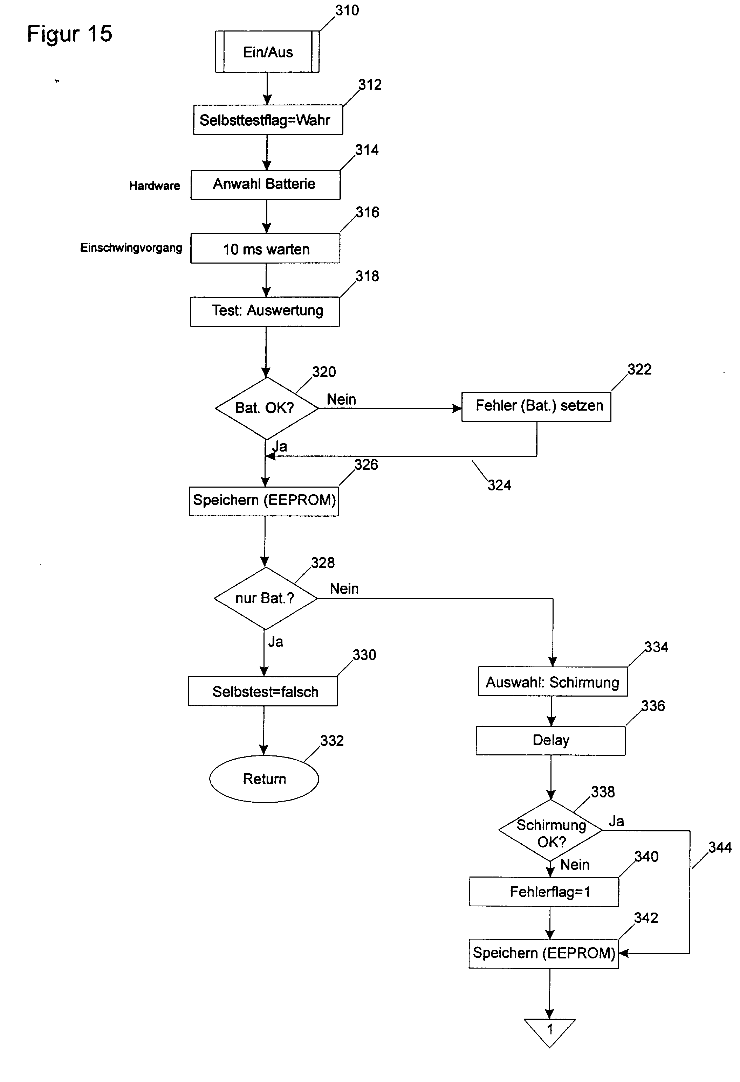

Das Hauptprogramm steuert zunächst eine Selbstprüfung des Phasenvergleichers. Es werden nacheinander die Batterie, die Schirmung, die Leuchtdioden der Anzeige und Spannungs- und Phasenmessung geprüft. Ein Ablaufdiagramm dieses Teiles des Hauptprogrammes ist in den Figuren 15, 16 und 17 dargestellt, die sich aneinander anschließende Abschnitte des Ablaufdiagramms darstellen.

In Fig. 15 ist zunächst die EIN/AUS-Schaltung gemäß Fig. 14 als Rechteck 310 dargestellt, wobei davon ausgegangen wird, daß eine Einschaltung erfolgte. Es wird dann ein Selbstprüfungs-Kennzeichen (Flag) gesetzt. Dieses Selbstprüfungs-Kennzeichen signalisiert dem Gerät, daß ein Selbstprüfungs-Programm läuft und z.B. keine Anzeige erfolgen soll. Das Setzen des Selbstprüfungs-Kennzeichens ist durch ein Rechteck 312 dargestellt. Daraufhin wird die Batterie für die Batterieprüfung gemäß Fig. 13 angewählt. Praktisch wird der Ausgang des Komparators 278 in Fig. 13 abgefragt. Das ist durch ein Rechteck 314 dargestellt. Vor der Auswertung der Batterieprüfung wird eine Wartezeit von 10 ms eingeschaltet, um Einschwingvorgänge zu berücksichtigen. Das ist durch ein Rechteck 316 dargestellt. Nach Ablauf dieser Zeit erfolgt die Auswertung der Batterieprüfung. Das ist durch ein Rechteck 318 dargestellt. Es wird bei der Auswertung geprüft, ob die Batterie einwandfrei ist, also die erforderliche Batterie-Spannung an der Klemme 276 in Fig. 13 anliegt. Das ist symbolisiert durch den Rhombus 320. Ist das nicht der Fall (Nein), dann wird ein Batteriefehler-Kennzeichen gesetzt. Das ist durch ein Rechteck 322 dargestellt. Von dort aus geht eine Schleife 324 wieder zurück zum normalen Programmablauf. Ist die Batterie in Ordnung (Ja), dann wird dieser Befund in einem EEPROM gespeichert. Das ist durch ein Rechteck 326 dargestellt.

Es wird dann gefragt, ob nur eine Batterieprüfung stattfinden oder das gesamte Prüfprogramm ablaufen soll. Die Batterie wird nicht nur beim Einschalten sondern auch zwischendurch im Verlauf der Messungen kontrolliert. Diese Frage ist in Fig. 15 durch einen Rhombus 328 dargestellt. Wenn nur eine Batterieprüfung erfolgen soll (Ja), wird das Selbstprüfungs-Kennzeichen wieder auf "logisch 0" zurückgesetzt. Das ist durch ein Rechteck 330 dargestellt. Das Ablaufdiagramm kehrt dann zu dem Hauptprogramm zurück. Das ist durch ein Oval 332 ("Return") dargestellt. Ist die Antwort auf die Frage "nein", dann läuft das Prüfprogramm weiter.

Es werden dann die Mittel zur Prüfung der Schirmung der Leitungen für die beiden Wechselspannungen L und $L_x$ angewählt, die in Fig. 2 mit 82 und 84 bezeichnet sind. Solche Mittel zur Prüfung einer Schirmung sind an sich bekannt und daher hier nicht im einzelnen beschrieben. Diese Anwahl der Mittel zur Prüfung der Schirmung ist durch ein Rechteck 334 dargestellt. Auch hier wird vor der Auswertung der Prüfung eine Verzögerung eingeschaltet, um Einschwingvorgängen Rechnung zu tragen. Das ist durch ein Rechteck 336 dargestellt. Dann wird geprüft, ob die Schirmung einwandfrei ist. Das ist wieder durch einen Rhombus 338 dargestellt. Wenn die Schirmung nicht einwandfrei ist (Nein), dann wird ein Schirmungsfehler-Kennzeichen gesetzt. Das ist durch ein Rechteck 340 dargestellt. Das Prüfergebnis wird in dem EEPROM gespeichert. Das ist durch ein Rechteck 342 dargestellt. Ist die Schirmung einwandfrei (Ja), dann wird auch dieses Prüfergebnis in dem EEPROM gespeichert. Das ist durch die Schleife 344 dargestellt.

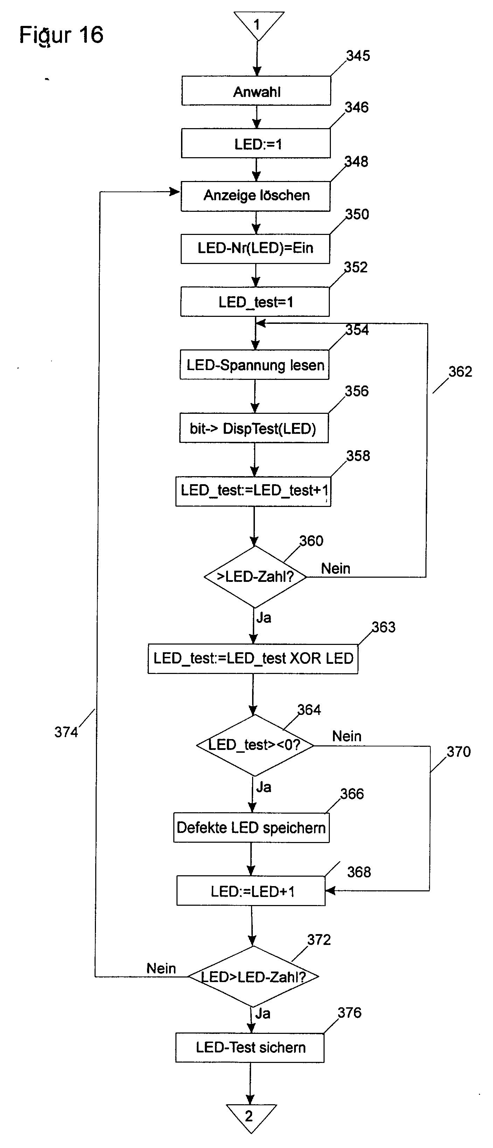

Das Prüfprogramm setzt sich mit dem Ablaufdiagramm von Fig. 16 fort, wie durch das Dreieck "1" angedeutet ist.

Fig. 16 zeigt die Prüfung der Leuchtdioden 196 bis 208 gemäß Fig. 10 und 11.

Es wird die Leuchtdioden-Prüfung "angewählt", d. h. es wird in der Schaltung von Fig. 10 und 11 die hierfür erforderliche Konfiguration von Eingaben und Ausgaben hergestellt. Das ist durch ein Rechteck 345 dargestellt. Die Leuchtdioden 196 bis 208 sind durch eine fortlaufende Zahl von "1" bis "7" gekennzeichnet und werden durch den Rechner 42 über den Bus 238 und die Schalter 224 bis 236 in dieser Reihenfolge nacheinander angesteuert.

Das Programm arbeitet mit zwei Variablen, die in zwei Zählern des Rechners 42 anstehen. Die erste Variable "LED" ist die Leuchtdiode, die bei der Leuchtdioden-Prüfung durch den Rechner 42 eingeschaltet wird. Die zweite Variable "$LED_{test}$" gibt die Leuchtdiode an, deren Brennspannung jeweils mit dem Fensterkomparator 86 geprüft werden soll. Bei intakter Anzeigevorrichtung 76 sollte nur die jeweils eingeschaltete Leuchtdiode brennen, während an den übrigen Leuchtdioden keine Brennspannung abfällt.

Zu diesem Zweck wird der Rechner 42 zunächst auf eine "LED"-Zahl =1 gesetzt. Das ist durch ein Rechteck 346 dargestellt. Eine vorherige Anzeige der Leuchtdioden wird gelöscht. Das ist durch ein Rechteck 348 dargestellt. Dann schaltet der Rechner 42 über den Schalter 226 zunächst die Leuchtdiode 196 ("1") ein. Das ist durch ein Rechteck 350 dargestellt. Der Zähler für die jeweils zu prüfende Leuchtdiode wird auf $LED_{test}$=1 gesetzt. Es erfolgt dann zunächst eine Prüfung der Brennspannung der Leuchtdiode 196 mittels des Fensterkomparators 86 von Fig.11. Das ist durch ein Rechteck 354 dargestellt. Das Ergebnis der Prüfung wird als Bit eines Bitmusters in der zugeordneten Speicherstelle gesetzt. Das ist durch ein Rechteck 356 dargestellt. Dann wird der Rechner 42 auf die nächste "$LED_{test}$"-Zahl fortgeschaltet. Das ist durch ein Rechteck 358 dargestellt. Es wird geprüft, ob damit die Gesamtzahl der vorhandenen Leuchtdioden überschritten ist. Das ist durch den Rhombus 360 dargestellt. Ist das noch nicht der Fall (Nein), dann wird der Programmablauf über Schleife 362 wieder zu dem "Eingang" des Rechtecks 354 zurückgeführt. Es wird -bei weiter eingeschalteter Leuchtdiode 196- die Brennspannung der der Leuchtdiode 198 ("2"), geprüft und das Prüfergebnis als zweiter Bit in dem Bitmuster gespeichert. Dann erfolgt wieder eine Fortschaltung auf die nächste "$LED_{test}$"-Zahl. Das setzt sich mit wiederholtem Durchlaufen der Schleife fort, bis bei dieser Fortschaltung die Gesamtzahl der Leuchtdioden überschritten wird. Dann ist das Ergebnis der Abfrage an Rhombus 360 "ja". Es ist dann ein Bitmuster gespeichert, das bei intakter Anzeigevorrichtung 0000001 ist: Die eingeschaltete Leuchtdiode 196 brennt und liefert eine Brennspannung innerhalb des durch den Fensterkomparator 86 vorgegebenen Fensters, die anderen Leuchtdioden 198 bis 208 brennen nicht. Das aus den Prüfungen des Fensterkomparators 86 erhaltene Bitmuster (z.B. 0000001) wird nun mit einem Bitmuster, in dem eine der eingeschalteten Leuchtdiode, hier der Leuchtdiode 196) entsprechende Stelle durch eine "1" und die übrigen Stellen durch eine "0" gekennzeichnet sind, einer Exklusiv-ODER-Verknüpfung unterworfen. Wenn an einer nicht eingeschalteten Leuchtdiode eine "1" auftritt, oder wenn eine eingeschaltete Leuchtdiode keine Brennspannung liefert und ein Bit "0" erzeugt, dann liefert die Exklusiv-ODER-Verknüpfung einen Ausgang "logisch 1". Wenn nur die eingeschaltete Leuchtdiode eine Brennspannung liefert, dann ist der Ausgang der Exklusiv-ODER-Verknüpfung "0". Entweder sind dann zwei Eingänge "1" oder beide Eingänge "0". Diese Exklusiv-Oder-Verknüpfung ist durch ein Rechteck 363 dargestellt. Ist das Ergebnis der Exklusiv-ODER-Verknüpfung >0 (Ja), dann ist eine Leuchtdiode defekt. Diese Prüfung ist durch einen Rhombus 364 dargestellt. In diesem Fall verläuft das Ablaufdiagramm weiter zu Rechteck 366. Das Rechteck 366 symbolisiert die Speicherung der Nummer der defekten Leuchtdiode. Daraufhin wird die Variable LED, d. h. die Nummer der einzuschaltenden Leuchtdiode um 1 erhöht. Das ist durch ein Rechteck 368 dargestellt. Wenn die Exklusiv-ODER-Verknüpfung 362 nicht >0 ist (Nein), dann geht das Ablaufdiagramm über eine Schleife 370 unmittelbar zu dem Rechteck 368.

Die nächste, durch einen Rhombus 372 dargestellte Prüfung ist darauf gerichtet, ob die Variable LED nach der Erhöhung um 1 größer als die Gesamtzahl der Leuchtdioden ist. Wenn das nicht der Fall ist (Nein), dann führt eine Schleife 374 zurück zu dem Rechteck 348 "Anzeige löschen". Die Leuchtdiode 196 wird gelöscht. Es wird jetzt die nächste Leuchtdiode 198 eingeschaltet, die der um 1 erhöhten LED-Zahl entspricht. Dann läuft der Prüfvorgang für alle Leuchtdioden von der Leuchtdiode 196 ($LED_{test}$-Zahl "1") über die eingeschaltete Leuchtdiode 198 bis zu der Leuchtdiode 208 erneut ab. Das geht so weiter, bis schließlich die Leuchtdiode 208 (LED-Zahl=7) eingeschaltet ist und nach dem Prüfvorgang die Erhöhung der LED-Zahl um 1 eine die Anzahl der Leuchtdioden überschreitende Zahl liefert. Dann wird das Prüfergebnis gesichert. Das ist durch ein Rechteck 376 dargestellt.

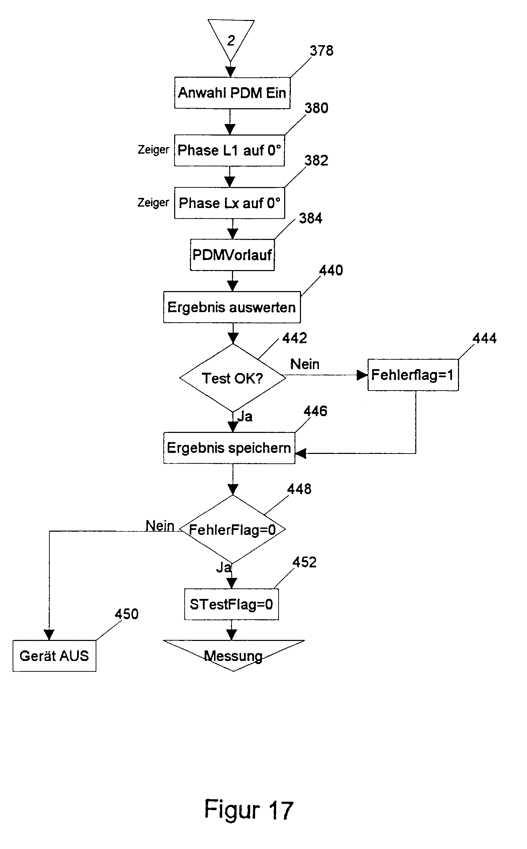

Das Ablaufdiagramm geht dann über zu Fig.17. Das ist durch die mit "2" bezeichneten Dreiecke angedeutet.

Gemäß Fig.17 erfolgt eine Selbstprüfung der Phasenmessung. Zu diesem Zweck werden zwei Wechselspannungen mit definierter relativer Phasenlage erzeugt. Die Phasenlagen dieser Wechselspannungen werden auf die eingangs unter Bezugnahme auf die Figuren 4 und 6 beschriebene Weise bestimmt. Es wird geprüft, ob die so bestimmten Phasenlagen mit den Phasenlagen der für die Prüfung erzeugten Wechselspannungen übereinstimmen. Zur Bildung der Wechselspannungen sind die Werte der Wechselspannung in einem Speicher als Tabelle abgelegt. Die Werte werden durch "Zeiger" nacheinander in festem Zeittakt aufgerufen und auf zwei Kanäle aufgeschaltet. Die Zeiger können dabei die Werte synchron aufreufen. In diesem Fall werden zwei gleichphasige Wechselspannungen erzeugt. Die Zeiger können die Werte aber auch mit einem Versatz aufrufen, also bildlich gesprochen jeweils auf verschiedenen "Zeilen" der "Tabelle" stehen. In diesem Fall werden zwei gegeneinander phasenverschobene Wechselspannungen erzeugt. Die jeweils in einem vorgegebenen Zeittakt aufgerufenen Werte der Wertetabelle werden in Impulse entsprechender Dauer umgesetzt (Pulsdauermodulation). Es entstehen somit Impulsfolgen mit Impulsen unterschiedlicher Breite, entsprechend dem Verlauf der zu erzeugenden Wechselspannung. Diese Impulsfolgen werden gefiltert und liefern Wechselspannungen mit dem der Tabelle entsprechenden Signalverlauf. Dieser Signalverlauf ist üblicherweise sinusförmig. Es können aber in gleicher Weise auch z.B. sägezahn- oder dreieckförmige Signalverläufe erzeugt werden.

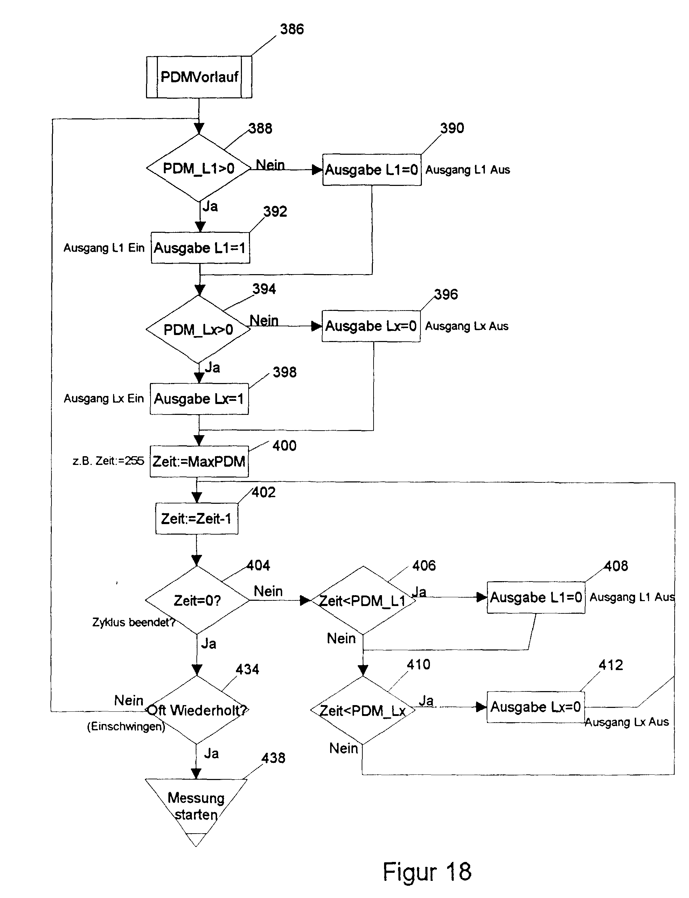

In Fig.17 wird die Pulsdauermodulation (PDM) "angewählt". Die Versorgungsspannung für die Verstärker 94 und 94 (Fig.12) angelegt und die Ausgänge 98 und 100 aktiviert. Das ist durch ein Rechteck 378 dargestellt. Die "Zeiger" für die beiden zu erzeugenden Wechselspannungen L und $L_x$ werden auf 0° gesetzt. Das ist in Fig.17 durch die Rechtecke 380 und 382 dargestellt. Dann läuft das in Fig.17 durch Rechteck 384 dargestellte Unterprogramm "PDM-Vorlauf" ab. Dieses Unterprogramm ist in Fig.18 dargestellt. Das Unterprogramm enthält nach dem durch Rechteck 386 dargestellten Start eine Abfrage "$PDM_L > 0$ ?". Das ist durch einen Rhombus 388 dargestellt. Dabei ist $PDM_L$ der in der Tabelle abgelegte Wert für L. Ist das nicht der Fall (Nein), dann wird an der Leitung 98 (Fig.2) das Signal "0" ausgegeben. Das ist durch Rechteck 390 dargestellt. Ist das der Fall, dann wird an dem Ausgang 98 das Signal "logisch 1" ausgegeben. Das ist in Fig.18 durch ein Rechteck 392 dargestellt. In beiden Fällen geht das Ablaufdiagramm dann weiter zu einer Abfrage "$PDM_{Lx} > 0$ ?". Das ist in Fig.18 durch einen Rhombus 394 dargestellt. Dabei ist $PDM_{Lx}$ die für die zweite Wechselspannung $L_x$ in der Tabelle abgelegte Spannung. Die beiden Werte $PDM_L$ und $PDM_{Lx}$ können voneinander verschieden sein, wenn die Zeiger auf verschiedenen "Zeilen" der Tabelle stehen. Wenn die Frage zu verneinen ist (Nein), wird an dem Ausgang 100 das Signal "0" erzeugt. Das ist durch ein Rechteck 396 dargestellt. Ist die Frage zu bejahen (Ja), dann wird an dem Ausgang 100 das Signal "logisch 1" erzeugt. Das ist durch ein Rechteck 398 dargestellt.

Dann wird ein Zeitzähler auf die maximal mögliche Pulsdauer "MaxPDM" gesetzt. Diese maximal mögliche Pulsdauer kann beispielsweise 255 Zeittakte des Takterzeugers 60 (Fig.2) betragen. Das Setzen des Zeitzählers auf die maximal mögliche Pulsdauer ist durch ein Rechteck 400 dargestellt. Dieser Zeitzähler wird dann schrittweise heruntergezählt. "Zeit" bedeutet den Zählerstand des Zeitzählers. Dieser Zählerstand wird beim nächsten Takt um 1 vermindert. Das ist durch ein Rechteck 402 dargestellt.

Die Signale "logisch 1" an den Ausgängen 98 und 100 bleiben bestehen, bis sie im Verlauf des Unterprogramms geändert werden.

Es folgen dann verschiedene Abfragen: Ist der Zeitzähler leergezählt, d.h. würde nach der Verminderung des Zählerstandes um eins der Zählerstand "Zeit" gleich null ? Das ist durch einen Rhombus 404 dargestellt. Wenn das nicht der Fall ist (Nein), dann folgt die nächste, wieder durch einen Rhombus 406 symbolisierte Abfrage: Ist der Zählerstand "Zeit" kleiner als der durch den "Zeiger" für die erste Wechselspannung gerade abgegriffene Wert aus der Tabelle, nämlich $PDM_L$ ? Wenn das der Fall ist (Ja), dann wird am Ausgang 98 das Signal "0" ausgegeben. Der Ausgang 98 kippt somit von "logisch 1" auf "0". Das ist durch ein Rechteck 408 dargestellt. Es wird bei "Ja" und "Nein" an dem Rhombus 406 weiter geprüft, ob der Zählerstand "Zeit" kleiner als der durch den zugehörigen Zeiger für die zweite Wechselspannung gerade abgegriffene Wert der Tabelle ist.

Das ist durch einen Rhombus 410 dargestellt. Ist Zeit < $PDM_{Lx}$ (Ja), wird der Ausgang 100 auf "0" gesetzt. Das ist in Fig.18 durch ein Rechteck 412 dargestellt. In diesem Fall wird ebenso wie nach dem Nullsetzen des Ausgangs 100 über eine Schleife 414 der Zählerstand des Zeitzählers um 1 vermindert.

Dann wird die beschriebene Schleife weiter durchlaufen, bis schließlich bei der Abfrage gemäß Rhombus 404 "Zeit = 0 ?" die Antwort "Ja" wird.

Mit diesem Zyklus wird je ein Impuls mit konstanter Höhe an den Ausgängen 98 und 100 erzeugt, wobei die Dauer des Impulses jeweils von dem digital gespeicherten und ausgelesenen Wert $PDM_L$ bzw. $PDM_{Lx}$ bestimmt ist. Es werden nun nacheinander alle Werte der Tabelle auf die geschilderte Weise in Impulse variabler Breite umgesetzt. Die Vorderflanken der Impulse haben jeweils gleiche Abstände voneinander. Die Dauer jedes Impulses hängt von dem jeweiligen gespeicherten Wert $PDM_L$ oder $PDM_{Lx}$ ab. Auf diese Weise werden von den Wechselspannungen mehrere Zyklen erzeugt.

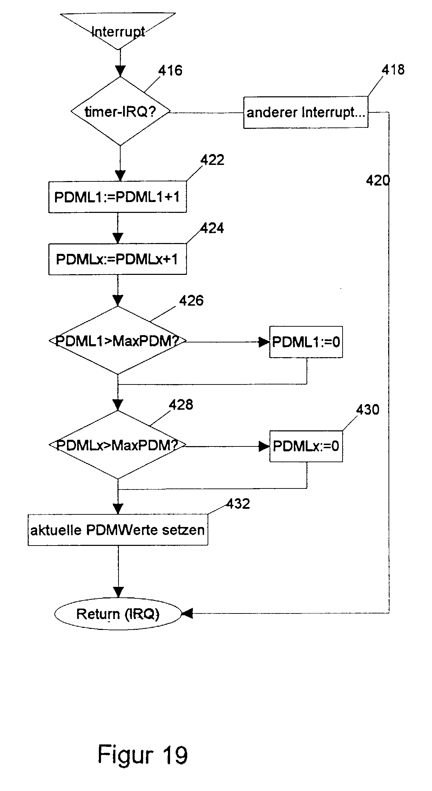

Das ist in Fig.19 als Ablaufdiagramm dargestellt.

In festen Zeitabständen, die durch einen Zeitgeber festgelegt und etwas länger als die maximal mögliche Pulsdauer sind, wird das Unterprogramm von Fig.18 unterbrochen. Es wird zunächst geprüft, ob die Unterbrechung tatsächlich durch den Zeitgeber veranlaßt ist. Das ist durch einen Rhombus 416 dargestellt. Wenn das nicht der Fall ist (Nein), dann hat die unterbrechung andere Ursachen. Das ist durch ein Rechteck 418 dargestellt. In diesem Fall erfolgt über eine Schleife 420 die Rückkehr in das Unterprogramm von Fig.18. Ist die Unterbrechung auf den Zeitgeber zurückzuführen (Ja), dann schalten die "Zeiger" auf die nächste Zeile der Tabelle von gespeicherten Signalwerten weiter. Das ist durch die Rechtecke 422 und 424 für die beiden Wertesätze $PDM_L$ und $PDM_{Lx}$ dargestellt. Es wird geprüft, ob der dann erhaltenen $PDM_L$-Wert größer als die maximal mögliche Pulsdauer MaxPDM ist. Das ist durch einen Rhombus 426 dargestellt. Wenn dies der Fall ist (Ja), wird der Wert für $PDM_L$ auf 0 gesetzt. Anschließend erfolgt in gleicher Weise eine Prüfung, ob der $PDM_{Lx}$-Wert größer als die maximal mögliche Pulsdauer ist. Das ist durch einen Rhombus 428 dargestellt. Wenn dies der Fall ist (Ja), wird der Wert für $PDM_{Lx}$ auf 0 gesetzt. Das ist durch ein Rechteck 430 dargestellt. In beiden Fällen werden dann in dem Unterprogramm von Fig.18 die Werte für $PDM_L$ und $PDM_{Lx}$ durch die gemäß Fig.19 gebildeten aktuellen Werte ersetzt. Das ist in Fig.19 durch ein Rechteck 432 dargestellt. Es erfolgt dann ein Rücksprung in das Unterprogramm von Fig.18. Diese Unterbrechung und Weiterschaltung der Zeiger erfolgt jeweils im festen Takt des Zeitgebers.

In dem Unterprogramm von Fig.18 erfolgt dann eine Abfrage "Oft wiederholt", d.h. es wird gefragt, ob der beschriebene Zyklus mehrfach wiederholt wurde, um Einschwingvorgänge z.B. an Verstärkern zu berücksichtigen. Diese Abfrage ist durch einen Rhombus 434 dargestellt. Wenn das nicht der Fall ist (Nein) springt das Ablaufdiagramm über eine Schleife 436 wieder zum Start, nämlich zu dem Rhombus 388. Dann wird das gesamte Unterprogramm noch einmal durchlaufen. Ist die Antwort bejahend (Ja), geht das Programm zu der Messung im Verlauf der Selbstprüfung über. Das ist in Fig. 18 durch ein Rechteck 438 dargestellt.

Das geschilderte Programm liefert Pulsfolgen mit einer festen Frequenz, wobei sich die Pulsbreiten nach Maßgabe der digital gespeicherten Werte der Tabelle verändern. Die so erhaltene pulsdauermodulierten Signale werden durch Filter 268, 272 bzw. 270, 274 geglättet und durch Verstärker verstärkt. Es entstehen Wechselspannungen mit vorgegebener Phasenbeziehung.

Die Phasenbeziehungen der so für Prüfzwecke erzeugten Wechselspannungen werden nach Art von Fig. 4 und 6 gemessen und mit der vorgegebenen Phasenbeziehung verglichen. Die erhaltenen Ergebnisse werden ausgewertet. Das ist in Fig.17 durch ein Rechteck 440 dargestellt. Ein Rhombus 442 in Fig.17 symbolisiert eine Abfrage, ob die Selbstprüfung ergab, daß die Mittel für die Phasenmessung einwandfrei arbeiten. Ist das nicht der Fall (Nein), wird ein Fehlerkennzeichen gesetzt. Das ist durch ein Rechteck 444 dargestellt. Das positive oder negative Ergebnis wird gespeichert. Das ist durch ein Rechteck 446 dargestellt. Schließlich wird untersucht, ob das Fehlerkennzeichen auf "0" gesetzt ist. Das ist durch einen Rhombus 448 dargestellt. Ergab sich ein Fehler, ist also das Fehlerkennzeichen nicht "0" (Nein), dann wird der Phasenvergleicher ausgeschaltet. Das ist durch ein Rechteck 450 dargestellt. Ist das Fehlerkennzeichen "0" (Ja), dann wird ein Selbstprüfungs-Kennzeichen auf "0" gesetzt. Das ist durch ein Rechteck 452 dargestellt. Dann kann die Messung beginnen.

Die Messung wird für die intern erzeugten Wechselspannungen wie für die zu prüfenden Spannungen mit den gleichen Mitteln durchgeführt.

Es werden zunächst die drei Nulldurchgänge A, B und C der Spannungen bestimmt. Im Zeitpunkt A geht das Signal von "logisch 0" auf logisch "1", im Zeitpunkt B geht das Signal von "logisch 1" auf "logisch 0" und im Zeitpunkt C geht das Signal wieder von "logisch 0" auf "logisch 1". Die Zeitpunkte A, B und C werden in bezug auf den Takt des Takterzeugers 60 festgelegt. Zur Frequenzprüfung werden die Periodendauern $T_L$ und $T_{Lx}$ für die beiden Wechselspannungen

$$T_L = C_L - A_L$$

$$T_{Lx} = C_{Lx} - A_{Lx}$$

gebildet. Die Periodendauern dürfen nicht mehr als 10% voneinander abweichen. Es muß

$$T_L / T_{Lx} \approx 1$$

sein. Ist das nicht der Fall, wird ein Fehlerkennzeichen gesetzt. Stimmen die Periodendauern und damit die Frequenzen der beiden Wechselspannungen im Rahmen der vorgegebenen Toleranzen überein, erfolgt eine Korrektur des Nullinien-Versatzes.

Wenn etwa der Nullpunktschalter 36 für die Wechselspannung L genau bei 0 Volt schaltet, also schaltet, wenn die Spannung L>0 wird, der Nullpunktschalter 52 für die Wechselspannung $L_x$ jedoch erst schaltet, wenn $L_x$>2 Volt wird, dann würde bei genau phasengleichen Wechselspannungen eine Phasenverschiebung angezeigt werden. Die Verschiebung der Nullinie führt dazu, daß bei der erzeugten Rechteckspannung die zeitlichen Abstände der Nulldurchgänge ungleich werden, wie in Fig.6 dargestellt ist. Aus dieser Ungleichförmigkeit läßt sich ein Korrekturwert für die Nulldurchgänge berechnen:

$$K = C/4 - B/2 + A/4.$$

Wenn A - B = B - C ist, dann wird dieser Korrekturwert null. Dieser Korrekturwert K muß von den Zeiten A und C subtrahiert werden. Dann erhält man korrigierte Zeiten A* bzw. B* für die Nulldurchgänge. Mit diesen Korrekturen würde sich in dem vorstehend angegebenen Beispiel keine Phasenverschiebung mehr ergeben.

Mit den so korrigierten Zeitpunkten für die Nulldurchgänge kann dann der Phasenwinkel Þ zwischen den beiden Wechselspannungen berechnet werden. Es wird:

$$Þ = 2 (A_L - A_{Lx}) 360° / [(C_L - A_L) + (C_{Lx} - A_{Lx})].$$

Der Phasenwinkel ergibt sich aus der Differenz der Zeitpunkte der ersten Nulldurchgänge der beiden Spannungen, dividiert durch den Mittelwert der Periodenlängen. Dieses Verhältnis wird mit 360° multipliziert.

Wenn der so berechnete Phasenwinkel kleiner als 45° ist, wird "Phase gleich" angezeigt. Anderenfalls erfolgt eine Anzeige "Phase ungleich". Während der Selbstprüfung, d.h. wenn das Selbstprüfungs-Kennzeichen (312 von Fig.15) gesetzt ist, wird das Ergebnis dieser Prüfung nicht durch die Anzeige 76 (Fig.2) angezeigt.

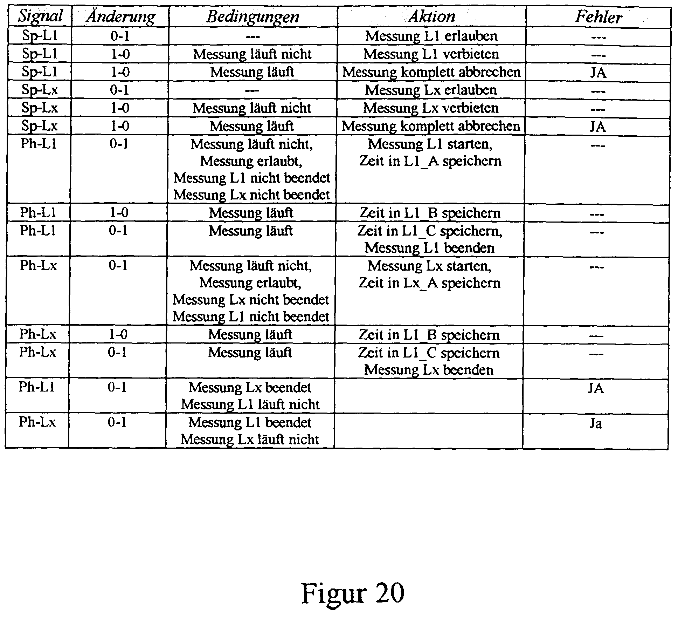

Zur Messung an den zu prüfenden, externen Wechselspannungen werden zunächst die relevanten Nulldurchgänge für beide Wechselspannungen aufgrund einer Fallunterscheidung bestimmt. Diese Fallunterscheidung ist in der Tabelle von Fig.20 dargestellt:

In der ersten Spalte der Tabelle sind Arten die verschiedenen Signale angegeben. Sp-L ist ein binäres Signal, aus welchem gemäß Fig.7 auf das Vorhandensein oder Nichtvorhandensein der Wechselspannung L geschlossen wird. Das ist der Ausgang eines Komparators, der die Zeit, z.B. $t_1$ mit einem Referenzwert vergleicht. Sp-Lx ist das entsprechende Signal für die

Wechselspannung $L_x$. Ph-L ist das Signal des Nullpunktschalters 36 am Eingang 40 des Rechners 42. Ph-Lx ist das Signal des Nullpunktschalters 50 am Eingang 54 des Rechners 42.

Die zweite Spalte der Tabelle gibt Änderungen dieser verschiedenen Signale an, z.B. von "logisch 0" auf "logisch 1" (0-1). Die dritte Spalte gibt an, unter welchen Bedingungen die Änderungen stattfinden, z.B. ob die Messung zum Zeitpunkt der Signaländerung läuft oder nicht. Die vierte Spalte gibt die sich aus der Signaländerung und der "Bedingung" ergebende Aktion an, z.B "Messung $L_x$ starten, Zeit $A_{Lx}$ speichern".

Wenn die Signale Sp-L und Sp-Lx gemäß Zeilen 1 und 4 der Tabelle sich von 0 auf 1 ändern, dann bedeutet das, daß die Spannungen L und $L_x$ vorhanden sind. Dann kann die Messung von L bzw. $L_x$ stattfinden. Gehen dagegen die Signale Sp-L und Sp-Lx gemäß Zeilen 2, 3 bzw. 5, 6 von 1 auf 0, dann hängen die daraus abzuleitenden Aktionen von den "Bedingungen" ab. Wenn die Messung noch nicht läuft, wird die Messung der betreffenden Wechselspannung "verboten", also gar nicht erst eingeleitet. Die Messung einer nicht vorhandenen Wechselspannung kann keine sinnvollen Ergebnisse bringen. Geschieht der Übergang von 1 auf 0, während die Messung läuft, dann ist die Messung gemäß Zeilen 3 und 6 der Tabelle vollständig abzubrechen. Dann liegt, wie in der letzten Zeile der Tabelle angegeben ist, ein Fehler vor.

Für die Änderung der Signale für die Phasenmessung sind eine größere Zahl von Fällen zu unterscheiden.

Wenn das Signal Ph-L sich von 0 auf 1 ändert und die Messung noch nicht läuft, die Messung gemäß Zeile 1 der Tabelle erlaubt ist und die Messungen sowohl von L als auch von $L_x$ noch nicht beendet sind, dann befinden wir uns im Punkt $A_L$ der Wechselspannung L, also im ersten Nulldurchgang. Die sich daraus ergebende Aktion ist, die Messung der Phase der Wechselspannung L zu starten und die Zeit $A_L$ in der entsprechenden Speicherstelle zu speichern. Das gleiche gilt sinngemäß für die Wechselspannung $L_x$ gemäß Zeile 10 der Tabelle von Fig.20.

Wenn das Signal Ph-L sich von 1 auf 0 ändert, während die Messung läuft, dann zeigt dies einen Nulldurchgang der Wechselspannung vom Positiven zum Negativen hin an.

Das ist der Zeitpunkt $B_L$. Diese Zeit $B_L$ wird in der zugehörigen Speicherstelle gespeichert. Das gleiche gilt sinngemäß für das Signal Ph-Lx gemäß Zeile 11 der Tabelle.

Wenn schließlich das Signal Ph-L sich von 0 auf 1 ändert (Zeile 9), während die Messung läuft, dann ist der dritte Nulldurchgang $C_L$ der Wechselspannung L erreicht. Dann wird diese Zeit als $C_L$ in der zugehörigen Speicherstelle gespeichert. Die Messung von L ist beendet. Das wird durch ein entsprechendes Kennzeichen signalisiert. Das gleiche gilt sinngemäß für das Signal Ph-Lx. Das ist in Zeile 12 angegeben. Von den in den Zeilen 7 und 10 behandelten Situationen unterscheiden sich die in den Zeilen 9 und 12 behandelten Situationen dadurch, daß im ersteren Falle die Messung noch nicht läuft, im letzteren Falle aber der Übergang bei laufender Messung erfolgt.

In den letzten beiden Zeilen sind Fälle behandelt, wo die Signale Ph-L und Ph-Lx sich von 0 auf ändern, während die Messung der jeweils anderen Wechselspannung $L_x$ bzw. L beendet ist und die Messung der zugehörigen Wechselspannung nicht läuft. In diesen Fällen wird ein Fehler signalisiert.

Die so gespeicherten Daten werden in der oben geschilderten Weise zur Erzeugung einer Anzeige verarbeitet. Bei der Messung der äußeren Wechselspannungen werden die Ergebnisse der Messung durch die Leuchtdioden 196 bis 208 angezeigt, im Gegensatz zu den Ergebnissen, die bei der Selbstprüfung erhalten werden.

Die Verarbeitung der Daten bei der Messung der äußeren Spannung erfolgt notwendigerweise durch die gleichen Mittel und Programme, durch die auch die Verarbeitung der intern erzeugten Wechselspannungen erfolgt. Die intern erzeugten Wechselspannungen werden dabei weiter erzeugt und nach den obigen Beziehungen verarbeitet. Wenn Daten der zu prüfenden, äußeren Wechselspannungen vorliegen, dann erfolgt eine Programmunterbrechung. Das Prüfprogramm wird unterbrochen und die Rechenoperationen werden mit den Daten A, B und C der äußeren Wechselspannungen durchgeführt. Dann läuft das Prüfprogramm an der gleichen Stelle weiter. Wenn die Messung der äußeren Wechselspannungen beendet ist und keine Meßfehler festgestellt wurden, wird die Erzeugung und Messung der internen Wechselspannungen abgebrochen.

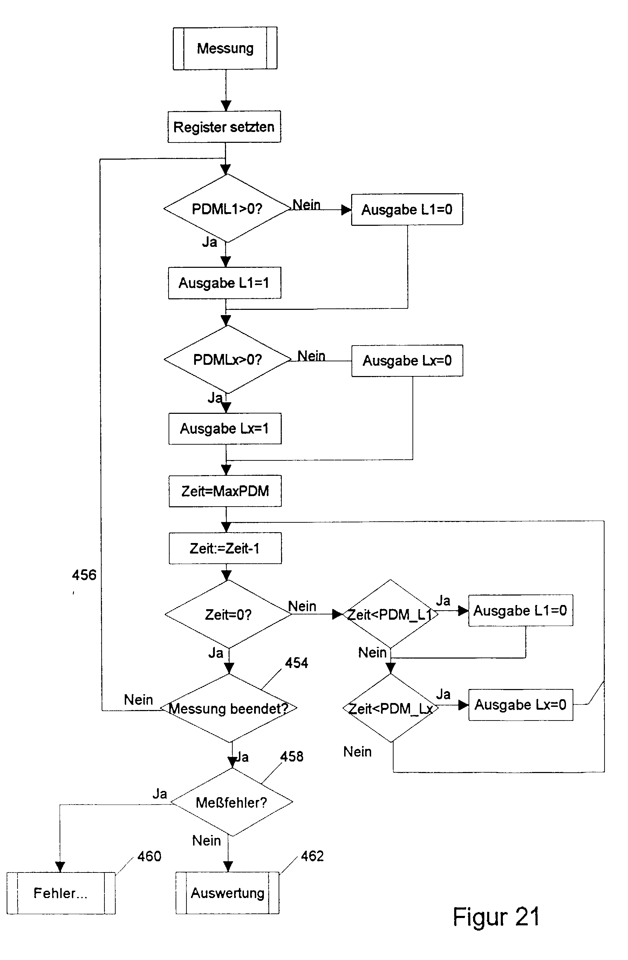

Das ist in Fig.21 dargestellt. Fig.21 entspricht im wesentlichen der schon behandelten Fig.18. Vergleichbare Elemente des Ablaufdiagramms sind mit den gleichen Bezugszeichen versehen wie dort. Im Anschluß an die Prüfung "Zeit=0" (Rhombus 404) erfolgt jedoch eine Prüfung "Messung beendet". Das ist durch einen Rhombus 454 in Fig.21 dargestellt. Ist die Antwort "Nein", dann wird das Ablaufdiagramm durch eine Schleife 456 wie Schleife 436 von Fig.18 wieder zum Start des Programms zurückgeführt. Ist die Antwort "Ja", dann wird geprüft, ob Meßfehler vorliegen. Das ist durch einen Rhombus 458 dargestellt. Wenn Meßfehler vorliegen (Ja), wird ein Fehler registriert. Das ist durch ein Rechteck 460 dargestellt. Ist kein Meßfehler festgestellt (nein), erfolgt die Auswertung der Messung. Das ist in Fig.21 durch ein Rechteck 462 dargestellt.

**Patentansprüche**

1. Phasenvergleicher zum Messen von Phasenwinkeln zwischen zwei Wechselspannungen (160,162), mit

(a) Mitteln (60) zum Erzeugen eines Zeittaktes, **gekennzeichnet durch**

(b) Nullpunktschalter (36,50) zum Bestimmen der Zeitpunkte von wenigstens jeweils drei Nulldurchgängen (A,B,C) jeder der beiden Wechselspannungen (160,162) in Bezug auf diesen Zeittakt, und

(c) Mittel zum Bestimmen der Phasenlagen jeder der beiden Wechselspannungen (160,162) bezogen auf den Zeittakt aus den jeweiligen Nulldurchgängen und

(d) Mittel zum Bestimmen der Differenz der so ermittelten Phasenlagen.

2. Phasenvergleicher nach Anspruch 1, **gekennzeichnet durch** Mittel zur Bestimmung und rechnerischen Berücksichtigung eines Nullinien-Versatzes der Wechselspannungen aus ungleichen Zeitabständen der Nulldurchgänge.

3. Phasenvergleicher nach Anspruch 2, dadurch gekennzeichnet, daß

(a) die Zeitpunkte A und C der beiden den Anfang und das Ende einer Wechselspannungs-Periode markierenden, jeweils im gleichen Sinne durch die Nullinie gehenden Nulldurchgänge jeweils um einen Korrekturwert

$$K = C/4 - B/2 + A/4$$

korrigiert werden, wobei B der Zeitpunkt des zwischen A und C liegenden, mittleren Nulldurchgangs ist und

(b) die Phasendifferenz $\Phi$ der beiden Wechselspannungen nach der Beziehung

$$\Phi = 2 \, ( A_L - A_{LX} ) \, 360° \, / \, [(C_L - A_L) + (C_{LX} - A_{LX})]$$

bestimmt wird, wobei in der Gleichung die Suffixe "L" und "LX" an den Zeitpunkten A und C auf die Zuordnung der Zeitpunkte zu den beiden hinsichtlich ihrer Phase zu vergleichenden Wechselspannungen L und LX hinweisen.

4. Phasenvergleicher nach einem der Ansprüche 1 bis 3, **gekennzeichnet durch**

(a) je einen Schwellwertschalter (38,52) für jede der beiden Wechselspannungen, auf den die Wechselspannung aufgeschaltet ist,

(b) Mittel zur Bestimmung des Zeitintervalls ($t_3$, $t_4$), während welches der Schwellwert (164) durch die jeweilige Wechselspannung (160,162) überschritten ist, und

(c) Mittel zur Anzeige, ob das Zeitintervall einen vorgegebenen Grenzwert unterschreitet als Anzeichen für das Vorhandensein oder Nichtvorhandensein der Wechselspannung.

5. Phasenvergleicher nach einem der Ansprüche 1 bis 4, **gekennzeichnet durch** Mittel zur Prüfung der Frequenzgleichheit der beiden Wechselspannungen vor der Bestimmung der Differenz der Phasen.

6. Phasenvergleicher nach den Ansprüchen 1 bis 5, **dadurch gekennzeichnet, daß** die Mittel zum Prüfen der Frequenzgleichheit, die Mittel zum Bestimmen der Phasenlagen und der Differenz der Phasenlagen, die Mittel zur Bestimmung des Nullinien-Versatzes und die zeitintervallbestimmenden und -auswertenden Mittel von einem hierfür programmierten Mikroprozessor (42) gebildet sind.

7. Phasenvergleicher nach einem der Ansprüche 1 bis 6, **dadurch gekennzeichnet, daß** er kapazitive Spannungsteiler (18,20;116,118) aufweist, die an die Phasen von Mittelspannungsanlagen anlegbar sind, wobei die Wechselspannungen ($L,L_x$) an diesen Spannungsteilern (18,20;116,118) abgegriffen werden.

8. Phasenvergleicher nach Anspruch 1, **dadurch gekennzeichnet, daß** zur Anzeige des Phasenvergleichs binäre Anzeigeglieder (196,198,200,202, 204,206,208) vorhanden sind, welche zur Anzeige der Phasengleichheit ansteuerbar sind, wenn die Differenz der Phasen einen vorgegebenen Grenzwert unterschreitet und zur Anzeige der Phasenungleichheit, wenn die Differenz der Phasen den Grenzwert überschreitet.

9. Phasenvergleicher nach einem der Ansprüche 1 bis 8, **gekennzeichnet durch** Selbstprüfungsmittel zur Prüfung der Funktionsfähigkeit des Phasenvergleichers.

10. Phasenvergleicher nach Anspruch 9, **dadurch gekennzeichnet, daß** die Selbstprüfungsmittel mikroprozessorgesteuert sind.

11. Phasenvergleicher nach Anspruch 9 oder 10, **dadurch gekennzeichnet, daß** die Selbstprüfungsmittel Mittel (80) zur Kontrolle der Batteriespannung einer den Phasenvergleicher speisenden Batterie enthalten.

12. Phasenvergleicher nach Anspruch 11, **dadurch ge-**

**kennzeichnet, daß**

(a) die Mittel zur Kontrolle der Batteriespannung einen Komparator enthalten, an welchem einerseits eine von der Versorgungsspannung abgeleitete, stabilisierte Referenzspannung und andererseits eine an einem Spannungsteiler abgegriffene Teilspannung der Batteriespannung anliegt, und

(b) in Reihe mit dem Spannungsteiler die Emitter-Kollektor-Strecke eines Transistors geschaltet ist, dessen Basis von einer aus der Versorgungsspannung abgeleiteten Spannung beaufschlagt ist, welche den Transistor bei Vorhandensein der Versorgungsspannung aufsteuert.

13. Phasenvergleicher nach Anspruch 9 oder 10, **dadurch gekennzeichnet, daß** die Selbstprüfungsmittel Mittel (86) zum Prüfen von Anzeige-Bauteilen (196,198,200,202,204,206,208) aufweisen, durch welche Ergebnisse des Phasenvergleichers anzeigbar sind.

14. Phasenvergleicher nach Anspruch 13, **dadurch gekennzeichnet, daß** die AnzeigeBauteile Leuchtdioden (196, 198,200,202,204,206,208) sind.

15. Phasenvergleicher nach Anspruch 14, **dadurch gekennzeichnet, daß** die Mittel zum Prüfen der Leuchtdioden (196,198,200,202,204,206,208) von einem Fensterkomparator (86) gebildet sind, auf welchen nacheinander die Brennspannungen der einzelnen Leuchtdioden (196,198,200,202,204, 206,208) aufschaltbar sind und welcher signalisiert, ob diese Brennspannung innerhalb vorgegebener Spannungsfenster liegt.

16. Phasenvergleicher nach Anspruch 15, **dadurch gekennzeichnet, daß**

(a) der Fensterkomparator (86) einen ersten und einen zweiten Komparator (242,244) mit je einem ersten und einem zweiten Eingang aufweist, wobei jeder der Komparatoren (242,244) einen Ausgang Logisch 1 liefert, wenn die an dem ersten Eingang anliegende Spannung größer ist als die an dem zweiten Eingang anliegende,

(b) an dem ersten Eingang des einen Komparators (242) eine an einem Spannungsteiler (246,248,250) abgegriffene obere Referenzspannung anliegt und an dem zweiten Eingang des anderen Komparators (244) eine an dem Spannungsteiler (246,248,250) abgegriffene untere Referenzspannung anliegt,

(c) an dem zweiten Eingang des ersteren Komparators (242) und an dem ersten Eingang des zweiten Komparators (244) jeweils die Brennspannung einer der Leuchtdioden (196,198,200, 202,204,206,208) über einen von dem Rechner (42) gesteuerten elektronischen Schalter (226,228,230,232,234,236) anlegbar ist und

(d) die Ausgänge der beiden Komparatoren (242,244) über ein UND-Glied (256) verknüpft sind.

17. Phasenvergleicher nach Anspruch 16, **dadurch gekennzeichnet, daß**

(a) ein Teil der der Leuchtdioden (196,200,204) von dem anderen Teil verschiedene Farben besitzen und niedrigere Brennspannungen zeigen,

(b) die Ansteuerspannungen der hierzu gehörigen elektronischen Schalter (224,228,232) auf die Eingänge eines ODER-Gliedes geschaltet sind,

(c) der Ausgang des ODER-Gliedes einen weiteren Schalter (262) ansteuert und

(d) über den weiteren Schalter ein Widerstand (264) parallel zu einem Teil des Spannungsteilers (246,248,250) geschaltet wird.

18. Phasenvergleicher nach Anspruch 9 oder 10, **dadurch gekennzeichnet, daß** die Selbstprüfungsmittel Mittel zur Selbstprüfung der Phasenmessung enthalten.

19. Phasenvergleicher nach Anspruch 14, **dadurch gekennzeichnet, daß** die Mittel zur Selbstprüfung der Phasenmessung enthalten:

- Mittel (94,96;98,100;102,104) zur internen Erzeugung eines Paares von gegeneinander um einen vorgegebenen Phasenwinkel phasenverschobenen Wechselspannungen,

- Mittel (106,108) zum Aufschalten dieser Wechselspannungen auf den Phasenvergleicher und

- Mittel zum Vergleichen des gemessenen Phasenwinkels mit dem besagten vorgegebenen Phasenwinkel.

20. Phasenvergleicher nach Anspruch 19, **dadurch gekennzeichnet, daß**

(a) die Mittel zur internen Erzeugung der Wechselspannungen ein in dem Rechner (42) gespeichertes Programm umfassen, durch welches

- eine in einem Speicher des Rechners (42) gespeicherte Wertetabelle des Signalverlaufs der intern zu erzeugenden Wechselspannungen durch Zeiger im Takt eines Zeitgebers schrittweise ausgelesen wird und

- die Werte der Wertetabelle in Ausgangspulse mit einer dem jeweiligen Wert entsprechenden Pulsbreite umgesetzt werden, und

(b) die Ausgangspulse durch Filter (268,272; 270,274) zur Erzeugung eines stetigen Signalverlaufs geglättet werden.

## Claims

1. Phase comparator for the measuring of phase angles between two alternating voltages (160, 162) with

    (a) means (60) for generating a clock signal, **characterized by**

    (b) zéro-crossover switches (36, 50) for the determination of moments of at least three zero-crossovers (A, B, C) of each of the two alternating voltages (160, 162) relative to this clock signal and

    (c) means for the determination of the phase of each of the two alternating voltages (160, 162) relative to the clock signal from the respective zero-crossovers and

    (d) means for determining the difference between the thus obtained phases.

2. Phase comparator according to claim 1, **characterized by** means for determining and computationally making allowance for a baseline offset of the alternating voltages from unequal time intervals between the zero-crossovers.

3. Phase comparator according to claim 2, **characterized in that**

    (a) the moments A and C of the two zero-crossovers marking the beginning and the end of a alternating voltage period, each of these zero-crossovers crossing the baseline in the same direction, are corrected by a correction value

    $$K = C/4 - B/2 + A/4$$

    wherein B is the moment of the intermediate zero-crossover between A and C and

    (b) the phase difference $\Phi$ of the two alternating voltages is determined according to

    $$\Phi = 2 (A_L - A_{LX}) 360° / [(C_L - A_L) + (C_{LX} - A_{LX})]$$

    wherein the suffixes "L" and "LX" at the moments A and C in the equation indicate the allocation of the moments to the two alternating voltages L and LX to be compared.

4. Phase comparator according to anyone of the claims 1 to 3, **characterized by**

    (a) a threshold switch (38, 52) for each of the alternating voltages ti which the alternating voltage is applied,

    (b) means for the determination of the time interval ($t_3$, $t_4$), during which the threshold (164) is exceeded by the respective alternating voltage (160, 162) and

    (c) means for displaying as to whether the time interval is less than a given threshold as an indication of the existence or non-existence of the alternating voltage.

5. Phase comparator according to anyone of the claims 1 to 4, **characterized by** means for testing the equality of the frequencies of the two alternating voltages before the determination of the difference of the phases.

6. Phase comparator according to anyone of claims 1 to 5, **characterized in that** the means for testing the equality of the frequencies, the means for the determination of the phase and the difference of the phase, the means for the determination of the baseline offset and the time interval determining and evaluating means are formed by a micro processor (42) which is programmed accordingly.

7. Phase comparator according to anyone of claims 1 to 6, **characterized in that** it has a capacitive voltage dividers (18, 20; 116, 118) which are connectable to the phases of medium voltage installations, the alternating voltages (L, $L_x$) being tapped from these voltage dividers (18, 20; 116, 118).

**8.** Phase comparator according to claim 1, **characterized in that** there are binary display members (196, 198, 200, 202, 204, 206, 208) for the display of the phase comparison, which are controllable for the display of phase coincidence when the phase difference is less than a given threshold and for the display of phase non-coincidence, when the phase difference exceeds the threshold.

**9.** Phase comparator according to anyone of claims 1 to 8, **characterized by** self-checking means for checking as to whether the phase comparator is operative.

**10.** Phase comparator according to claim 9, **characterized in that** the self-checking means are micro processor-controlled.

**11.** Phase comparator according to claim 9 or 10, **characterized in that** the self-checking means comprise means (80) for controlling the battery voltage of a battery supplying the current for the phase comparator.

**12.** Phase comparator according to claim 11, **characterized in that**

(a) the means for controlling the battery voltage comprise a comparator, to which, on one hand, a reference voltage is applied which is derived from the supply voltage and stabilized and, on the other hand, a partial voltage of the battery voltage which is tapped from a voltage divider and

(b) the emitter collector junction of a transistor is serially connected with the voltage divider, the base of the transistor being connected to a voltage which is derived from the supply voltage and which controls the transistor when the supply voltage is present.

**13.** Phase comparator according to claim 9 or 10, **characterized in that** the self-checking means comprise means (86) for the checking of display units (196, 198, 200, 202, 204, 206, 208) by means of which the results of the phase comparator are displayed.

**14.** Phase comparator according to claim 13, **characterized in that** the display units are LEDs (196, 198, 200, 202, 204, 206, 208).

**15.** Phase comparator according to claim 14, **characterized in that** the means for checking the LEDs (196, 198, 200, 202, 204, 206, 208) are formed by a window comparator (86) to which the operating voltages of the individual LEDs (196, 198, 200, 202, 204, 206, 208) are consecutively applied and which signalizes, whether the operating voltage is within a given voltage range.

**16.** Phase comparator according to claim 15, **characterized in that**

(a) the window comparator (86) has a first and a second comparator (242, 244) with first and second input each, each of the comparators (242, 244) providing a logic 1 output, if the voltage at its first input is higher than at its second input

(b) an upper reference voltage tapped from a voltage divider (246, 248, 250) is applied to the first input of one of the comparators (242) and a lower reference voltage tapped from the voltage divider (246, 248, 250) is applied to the second input of the other comparator (244),

(c) the operating voltage of one of the LEDs (196, 198, 200, 202, 204, 206, 208) is applied to the second input of the first comparator (242) and to the first input of the second comparator (244) respectively via an electronic switch (226, 228, 230, 232, 234, 236) which is controlled by a computer (42) and

(d) the outputs of the two comparators (242, 244) are combined throug an AND-element (256).

**17.** Phase comparator according to claim 16, **characterized in that**

(a) part of the LEDs (196, 200, 204) have colours different from the colours of the other part and lower operating voltages,

(b) the control voltages of the electronic switches (224, 228, 232) which are associated therewith are connected with the inputs of an OR-element,

(c) the output of the OR-element controls a further switch (262) and

(d) a resistor (264) is connected in parallel with a portion of the voltage divider (246, 248, 250) through the further switch.

**18.** Phase comparator according to claim 9 or 10, **characterized in that** the self-checking means comprise means for the self-checking of the phase measurement.

**19.** Phase comparator according to claim 14, **charac-**

**terized in that** the means for the self-checking of the phase measurement comprise

- means (94, 96; 98, 100; 102, 104) for the internal generation of a pair of alternating voltages which are phase shifted by a given phase angle relative to each other,

- means (106, 108) for applying these alternating voltages to the phase comparator and

- means for the comparison of the measured phase angle to the said given phase angle.

20. Phase comparator according to claim 19, **characterized in that**

(a) the means for the internal generation of the alternating voltages comprise a programm stored in the computer (42) by which

- a value table of the signal waveform of alternating voltages to be internally generated, which is stored in a memory of the computer (42), is, step by step read, by vectors with the cycle of a clock signal and

- the values of the value table are transformed to output pulses with a pulse width corresponding to the respective value and

(b) the output pulses are smoothed by filters (268, 272; 270, 274) to generate a continuous signal waveform.

**Revendications**

1. Phasemètre destiné à mesurer des angles de phase entre deux tensions alternatives (160,162) muni

(a) de moyens (60) destinés à générer un cycle, **caractérisés par**
(b) des commutateurs zéro (36,50) destinés à déterminer les moments d'au moins trois passages par zéro (A,B,C) respectivement de chacune des deux tensions alternatives (160,162) par rapport à ce cycle, et
(c) des moyens destinés à déterminer les relations des phases de chacune des deux tensions alternatives (160,162) par rapport au cycle à partir des passages par zéro respectifs et
(d) des moyens destinés à déterminer la différence des relations des phases ainsi recherchées.

2. Phasemètre selon la revendication 1, **caractérisé par** des moyens destinés à déterminer et à prendre en compte par des calculs un déport de la ligne zéro des tensions alternatives à partir d'intervalles de temps inégaux des passages par zéro.

3. Phasemètre selon la revendication 2, **caractérisé par le fait que**

(a) les moments A et C des deux passages par zéro passant respectivement dans le même sens par la ligne zéro et marquant le début et la fin d'une période de tension alternative sont respectivement corrigés par rapport à une valeur de correction

$$K = C/4 - B/2 + A/4,$$

B étant le moment du passage par zéro du milieu se trouvant entre A et C et
(b) la différence des phases $\Phi$ des deux tensions alternative est déterminée d'après la relation

$$\Phi = 2(A_L - A_{LX})360°/[(C_L - A_L) + (C_{LX} - A_{LX})],$$

les suffixes "L" et "LX" situés aux moments A et C indiquant dans l'équation la correspondance des moments avec les deux tensions alternatives L et LX devant être comparées en ce qui concerne leur phase.

4. Phasemètre selon l'une des revendications 1 à 3, **caractérisé par**

(a) chaque fois un commutateur de valeur de seuil (38,52) pour chacune des deux tensions alternatives auquel est appliquée la tension alternative,
(b) des moyens destinés à déterminer l'intervalle de temps ($t_3,t_4$) pendant lequel la valeur de seuil (164) est dépassée par la tension alternative respective (160,162), et
(c) des moyens destinés à afficher si l'intervalle de temps est inférieur à une valeur limite prédonnée en tant que signe indiquant la présence ou l'absence de tension alternative.

5. Phasemètre selon l'une des revendications 1 à 4, **caractérisé par** des moyens destinés à vérifier l'égalité de fréquence des deux tensions alternatives avant la détermination de la différence des phases.

6. Phasemètre selon les revendications 1 à 5, **caractérisé par le fait que** les moyens destinés à vérifier l'égalité de fréquence, les moyens destinés à déterminer les relations des phases et la différence des relations des phases, les moyens destinés à déterminer le déport de la ligne zéro et les moyens de détermination et d'évaluation de l'intervalle de temps sont formés par un microprocesseur (42) programmé à cet effet.

7. Phasemètre selon l'une des revendications 1 à 6, **caractérisé par le fait qu'**il présente des diviseurs de tension capacitifs (18,20;116,118) qui sont susceptibles d'être appliqués aux phases d'installations de distribution de courant moyenne tension, les tensions alternatives ($L, L_X$) étant captées à ces diviseurs de tensions (18,20;116,118).

8. Phasemètre selon la revendication 1, **caractérisé par le fait que** des membres d'affichage binaires (196,198,200,202,204,206,208) sont présents afin d'afficher la comparaison des phases, membres étant susceptibles d'être commandés afin d'afficher l'égalité des phases quand la différence des phases est inférieure à une valeur limite prédonnée et afin d'afficher l'inégalité des phases quand la différence des phases dépasse la valeur limite.

9. Phasemètre selon l'une des revendications 1 à 8, **caractérisé par** des moyens de vérification automatique destinés à vérifier l'aptitude à fonctionner du phasemètre.

10. Phasemètre selon la revendication 9, **caractérisé par le fait que** les moyens de vérification automatique sont commandés par un microprocesseur.

11. Phasemètre selon la revendication 9 ou 10, **caractérisé par le fait que** les moyens de vérification automatique comprennent des moyens (80) destinés à contrôler la tension de batterie d'une batterie alimentant le phasemètre.

12. Phasemètre selon la revendication 11, **caractérisé par le fait que**

(a) les moyens destinés à contrôler la tension de batterie comprennent un comparateur auquel est appliquée, d'un côté, une tension de référence stabilisée dérivée de la tension d'alimentation et ,d'un autre côté, une tension partielle de la tension de batterie captée à un diviseur de tension, et

(b) le rapport émetteur-collecteur d'un transistor à la borne de base duquel est appliquée une tension dérivée de la tension d'alimentation et commandant le transistor en présence de la tension d'alimentation est monté en série avec le diviseur de tension.

13. Phasemètre selon la revendication 9 ou 10, **caractérisé par le fait que** les moyens de vérification automatique présentent des moyens (86) destinés à vérifier des éléments d'affichage (196,198,200, 202,204,206,208) grâce auxquels des résultats du phasemètre sont susceptibles d'être affichés.

14. Phasemètre selon la revendication 13, **caractérisé par le fait que** les éléments d'affichage sont des diodes luminescentes (196,198,200,202,204,206, 208).

15. Phasemètre selon la revendication 14, **caractérisé par le fait que** les moyens destinés à vérifier les diodes luminescentes (196,198,200,202,204,206, 208) sont formés par un comparateur à fenêtre (86) auquel les tensions d'allumage des diodes luminescentes individuelles (196,198,200,202,204,206, 208) sont susceptibles d'être appliquées successivement et qui signale si cette tension d'allumage se trouve à l'intérieur de la fenêtre de tension prédonnée.

16. Phasemètre selon la revendication 15, **caractérisé par le fait que**

(a) le comparateur à fenêtre (86) présente un premier et un second comparateur (242,244) muni respectivement d'une première et d'une seconde entrée, chaque comparateur (242,244) fournissant une sortie Logique 1 quand la tension appliquée à la première entrée est supérieure à la tension appliquée à la seconde entrée,

(b) une tension de référence supérieure captée à un diviseur de tension (246,248,250) est appliquée à la première entrée d'un comparateur (242) et une tension de référence inférieure captée au diviseur de tension (246,248,250) est appliquée à la seconde entrée de l'autre comparateur (244),

(c) la chute de tension dans l'arc de l'une des diodes luminescentes (196,198,200,202,204, 206,208) est susceptible d'être appliquée respectivement à la seconde entrée du premier comparateur (242) et à la première entrée du second comparateur (244) par l'intermédiaire d'un commutateur électronique (226,228,230, 232,234,236) commandé par le calculateur (42) et

(d) les sorties des deux comparateurs (242,244) sont combinées par l'intermédiaire d'un membre ET (256).

17. Phasemètre selon la revendication 16, **caractérisé par le fait que**

(a) une partie des diodes luminescentes (196,200,204) possède des couleurs différentes de l'autre partie et possèdent des tensions d'allumage plus faibles,

(b) les tensions de commande des commutateurs électroniques (224,228,232) rattachés à celui-ci sont appliquées aux entrées d'un élément OU,

(c) la sortie de l'élément OU commande un autre commutateur (262) et

(d) une résistance (264) est montée en parallèle par rapport à une partie du diviseur de tension (246,248,250) par l'intermédiaire de l'autre commutateur.

18. Phasemètre selon la revendication 9 ou 10, **caractérisé par le fait que** les moyens de vérification automatique comprennent des moyens destinés à vérifier automatiquement le mesurage des phases.

19. Phasemètre selon la revendication 14, **caractérisé par le fait que** les moyens destinés à vérifier automatiquement le mesurage des phases comprennent :

- des moyens (94,96;98,100;102,104) destinés à générer de façon interne une paire de tensions alternatives à phases décalées l'une par rapport à l'autre par rapport à un angle de phases prédonné,
- des moyens (106,108) destinés à appliquer ces tensions alternatives au phasemètre et
- des moyens destinés à comparer l'angle de phase mesuré audit angle de phase prédonné.

20. Phasemètre selon la revendication 19, **caractérisé par le fait que**

(a) les moyens destinés à générer de façon interne les tensions alternatives comprennent un programme mémorisé dans le calculateur (42) grâce auquel

- une table de vérité mémorisée dans la mémoire du calculateur (42) de l'allure des signaux des tensions alternatives devant être générées de façon interne est sélectionnée progressivement par des indicateurs à la cadence d'un générateur de rythme et
- les valeurs de la table de vérité sont converties en impulsions de sortie ayant une durée d'impulsion correspondant à la valeur respective, et

(b) les impulsions de sortie sont égalisées par des filtres (268,272;270,274) afin de générer une allure de signaux constante.

*Fig. 1*

*Fig. 3*

*Fig. 2*

Blockschaltbild

Eingangsbeschaltung

- 24
- 30 Eingangs-impedanz
- 32 Eingangs-impedanz
- 34
- 36 Nullpunkt-schalter
- 38 Schwellwert-schalter
- 40
- 44 Signal-aufbereitung
- 46
- 48
- 50
- 52 Nullpunkt-schalter
- 54
- 56 Schwellwert-schalter
- 58 Signal-aufbereitung

Rechner

- 60 Taktterzeugung
- Microcontroller z.B. Microchip PIC 16C84
- 88
- 66
- 70 Porterwei-terung 1
- 72
- 74 Porterwei-rung 2
- 42

Stromversorgung

- 62 Stromver-sorgung
- 64 Ein-/Aus-Schaltung
- 68 Stabili-sierung
- Vcc

- 76 Anzeige
- 218
- 78 Selbstprüf-schalter
- Selbsttest

- 86 Fenster-komparator
- 80 Batterie-test
- 82 Schirmtest L1
- 84 Schirmtest Lx

- Diagnose-schnittstelle zum PC

Prüfsignalerzeugung

- 90 Externer Watchdog
- 92 DC/DC Auf-wärtswandler
- 100 Sinus-erzeugung L1
- 98
- 102 Sinus-erzeugung LX
- 94
- 96
- 104
- 106
- 108
- zu den Prüfbuchsen

- L
- Lx

*Fig. 4*

*Fig. 6*

148

146

Signal    Rv                    S - ampl.

130       144

Vcc

U
Ref.

150              152

*Fig.  5*

162

+U

160

Triggerschwelle

164

t

-U

t₄

t₃

166

Uₛ

t

*Fig.  7*

Signal  Rv

V c c

168    170

V c c

S - a m p l .

U
Ref.

-172

*Fig. 8*

Uconst.

Ohne Uconst.
= V c c

188    176

Versorgung
bzw. Batterie

192

174

Taster
Ein/
Aus

-180

186

184

182

Microcontoller
zB. PIC 16C84

MCLR

CLKIN

CLKOUT

190

Port B

0
1
2
3
4
5
6
7

194

Port A

0
1
2
3
4

62

178

*Fig. 9*

EP 0 706 054 B1

76

210
212

Vcc

222

z. Analogschalter

196

L1
Spv   L1
Spnv   Lx
Spv   Lx
Spnv   Ph
g   Ph
ug   F
Vh

198   200   202   204   206   208

214

216

v. Prozessor

220   218

**Figur 10**

EP 0 706 054 B1

v . d . LED 's — 222

v . Prozessor
Porterweiterg . 1
238

224
226
228
230
232
234
236

260

240

242

246
252
248
254
250

256
258
244

v . Prozessor Porterweiterg . 1

Fensterkomparator

262
264

86

Fig. 11

25

vom DC/DC
Aufwärtswandler

268

266

272

94

L

106

z. d. Prüfbuchsen

vom Prozessor

270

274

Lx

96

108

*Fig. 12*

294

288

286

80

290

292

276 Ubat

Vcc

282

296

280

U
Ref

z. Prozessor
o. Porterweiterung 2

278

284

*Fig. 13*

# Figur 14

298 — Ein/Aus

300 — Einschalten?

Nein

Ja

306 — Portsignal=0

302 — PortSignal=1

308 — Warten...

304 — Rücksprung zum Hauptprogramm

Figur 15

310
Ein/Aus

312
Selbsttestflag=Wahr

314
Hardware   Anwahl Batterie

316
Einschwingvorgang   10 ms warten

318
Test: Auswertung

320
Bat. OK? —Nein→ 322 Fehler (Bat.) setzen

Ja

324

326
Speichern (EEPROM)

328
nur Bat.? —Nein→

Ja

330
Selbstest=falsch

332
Return

334
Auswahl: Schirmung

336
Delay

338
Schirmung OK? —Ja→

Nein

340
Fehlerflag=1

344

342
Speichern (EEPROM)

1

Figur 16

```
        ▽ 1

         │
         ▼
   ┌──────────────┐  345
   │   Anwahl     │
   └──────────────┘
         │
         ▼
   ┌──────────────┐  346
   │   LED:=1     │
   └──────────────┘
         │
         ▼
   ┌──────────────┐  348
   │ Anzeige löschen│
   └──────────────┘
         │
         ▼
   ┌──────────────┐  350
   │ LED-Nr(LED)=Ein│
   └──────────────┘
         │
         ▼
   ┌──────────────┐  352
   │  LED_test=1  │
   └──────────────┘
         │
         ▼
   ┌──────────────┐  354
   │LED-Spannung lesen│
   └──────────────┘
         │
         ▼
   ┌──────────────┐  356
   │bit-> DispTest(LED)│
   └──────────────┘
         │
         ▼
   ┌──────────────┐  358
   │LED_test:=LED_test+1│
   └──────────────┘
         │
         ▼
      ◇ 360
   <>LED-Zahl?>── Nein ──┐  362
         │ Ja
         ▼
   ┌──────────────┐  363
   │LED_test:=LED_test XOR LED│
   └──────────────┘
         │
         ▼
      ◇ 364
   <LED_test><0?>── Nein ──┐  370
         │ Ja
         ▼
   ┌──────────────┐  366
   │Defekte LED speichern│
   └──────────────┘
         │
         ▼
   ┌──────────────┐  368
   │  LED:=LED+1  │
   └──────────────┘
         │
         ▼
      ◇ 372
 Nein ──<LED>LED-Zahl?>
         │ Ja
         ▼
   ┌──────────────┐  376
   │ LED-Test sichern│
   └──────────────┘
         │
         ▼
        ▽ 2
```

374

```
              ▽
              2         ⟋ 378

      ┌──────────────┐
      │ Anwahl PDM Ein│
      └──────────────┘      ⟋ 380
              │
              ▼
Zeiger ┌──────────────┐
      │ Phase L1 auf 0°│
      └──────────────┘      ⟋ 382
              │
              ▼
Zeiger ┌──────────────┐
      │ Phase Lx auf 0°│
      └──────────────┘
              │            ⟋ 384
              ▼
      ┌──────────────┐
      │ PDMVorlauf   │
      └──────────────┘      ⟋ 440
              │
              ▼
      ┌──────────────────┐
      │ Ergebnis auswerten│
      └──────────────────┘
              │            ⟋ 442
              ▼
           ╱──────╲      Nein      ┌──────────────┐  ⟋ 444
          ╱ Test OK? ╲──────────▶  │ Fehlerflag=1 │
           ╲──────╱                └──────────────┘
              │ Ja         ⟋ 446              │
              ▼                               │
      ┌──────────────────┐◀───────────────────┘
      │ Ergebnis speichern│
      └──────────────────┘
              │            ⟋ 448
              ▼
     Nein  ╱──────────╲
   ◀──────╱ FehlerFlag=0 ╲
           ╲──────────╱
              │ Ja        ⟋ 452
              ▼
      ┌──────────────┐
      │ STestFlag=0  │
      └──────────────┘
   ⟋ 450      │
      │       ▼
┌──────────┐  ▽
│ Gerät AUS│  Messung
└──────────┘
```

# Figur 17

PDMVorlauf — 386

PDM_L1>0 — 388

Nein → Ausgabe L1=0 — 390   Ausgang L1 Aus

Ja

Ausgang L1 Ein   Ausgabe L1=1 — 392

PDM_Lx>0 — 394

Nein → Ausgabe Lx=0 — 396   Ausgang Lx Aus

Ja

Ausgang Lx Ein   Ausgabe Lx=1 — 398

z.B. Zeit:=255   Zeit:=MaxPDM — 400

Zeit:=Zeit-1 — 402

Zeit=0? — 404   Nein → Zeit<PDM_L1 — 406   Ja → Ausgabe L1=0 — 408   Ausgang L1 Aus

Zyklus beendet?

Nein

Ja

Oft Wiederholt? — 434   Zeit<PDM_Lx — 410   Ja → Ausgabe Lx=0 — 412   Ausgang Lx Aus

Nein (Einschwingen)

Nein

Ja

Messung starten — 438

Figur 18

Interrupt

416 timer-IRQ? ————————→ anderer Interrupt... ——┐ 418

420

422 PDML1:=PDML1+1

424 PDMLx:=PDMLx+1

426 PDML1>MaxPDM? ————————→ PDML1:=0

428 PDMLx>MaxPDM? ————————→ PDMLx:=0   430

432 aktuelle PDMWerte setzen

Return (IRQ) ◄————————————————┘

Figur 19

| Signal | Änderung | Bedingungen | Aktion | Fehler |
|--------|----------|-------------|--------|--------|
| Sp-L1 | 0-1 | --- | Messung L1 erlauben | --- |
| Sp-L1 | 1-0 | Messung läuft nicht | Messung L1 verbieten | --- |
| Sp-L1 | 1-0 | Messung läuft | Messung komplett abbrechen | JA |
| Sp-Lx | 0-1 | --- | Messung Lx erlauben | --- |
| Sp-Lx | 1-0 | Messung läuft nicht | Messung Lx verbieten | --- |
| Sp-Lx | 1-0 | Messung läuft | Messung komplett abbrechen | JA |
| Ph-L1 | 0-1 | Messung läuft nicht, Messung erlaubt, Messung L1 nicht beendet Messung Lx nicht beendet | Messung L1 starten, Zeit in L1_A speichern | --- |
| Ph-L1 | 1-0 | Messung läuft | Zeit in L1_B speichern | --- |
| Ph-L1 | 0-1 | Messung läuft | Zeit in L1_C speichern, Messung L1 beenden | --- |
| Ph-Lx | 0-1 | Messung läuft nicht, Messung erlaubt, Messung Lx nicht beendet Messung L1 nicht beendet | Messung Lx starten, Zeit in Lx_A speichern | --- |
| Ph-Lx | 1-0 | Messung läuft | Zeit in L1_B speichern | --- |
| Ph-Lx | 0-1 | Messung läuft | Zeit in L1_C speichern Messung Lx beenden | --- |
| Ph-L1 | 0-1 | Messung Lx beendet Messung L1 läuft nicht | | JA |
| Ph-Lx | 0-1 | Messung L1 beendet Messung Lx läuft nicht | | Ja |

# Figur 20

Figur 21